# EUROPEAN PATENT SPECIFICATION

(11) **EP 2 610 673 B1**
(45) Date of publication and mention of the grant of the patent: **21.09.2016**
(21) Application number: 12195823.5
(22) Date of filing: 06.12.2012
(51) Int. Cl.: G03F 7/40

(54) **Method for manufacturing lithographic printing plates**
Verfahren zur Herstellung von Lithografiedruckplatten
Procédé de fabrication de plaques d'impression lithographiques

(30) Priority: 26.12.2011 JP 2011283845
(43) Date of publication of application: 03.07.2013
(73) Proprietor: FUJIFILM Corporation, Tokyo 106-0031 (JP)
(72) Inventor: Sonokawa, Koji, Shizuoka, 421-0396 (JP)
(74) Representative: Hoffmann Eitle

(56) References cited:
- EP-A1- 1 342 568
- EP-A2- 1 223 196
- WO-A2-2007/057442
- JP-A- S62 242 946
- JP-A- 2004 245 877
- JP-A- 2005 010 675
- US-A- 4 572 889

## Description

### BACKGROUND OF THE INVENTION

### Field of the Invention

The present invention relates to a method for manufacturing Lithographic printing plates.

### Description of the Related Art

Generally, a lithographic printing plate is comprised of a lipophilic image portion that receives ink and a hydrophilic non-image portion that receives fountain solution during the printing process. In lithographic printing plate, the mutually repelling property of water and oil-based ink is utilized. The lipophilic image portion of the lithographic printing plate is made the ink-receiving portion, and the hydrophilic non-image portion is made the fountain solution-receiving portion (non-ink-receiving portion). This produces a difference in ink adhesion on the surface of the lithographic printing plate. Once ink has been built up on the image portion alone, the ink is transferred to a print medium such as paper in this printing method.

To manufacture a lithographic printing plate, a lithographic printing plate precursor (PS plate), comprised of a lipophilic photosensitive resin layer (photosensitive layer) provided on a hydrophilic support, is widely employed. Normally, a lithographic printing plate is obtained by the method of exposing the lithographic printing plate precursor to light through an original image such as a lith film, retaining the photosensitive layer corresponding to the image portion, and dissolving away the unwanted photosensitive layer corresponding to the non-image portion with a strongly alkali developer of pH 12 or greater to expose the hydrophilic surface of the support and form the non-image portion. When the lithographic printing plate that has been thus fabricated is installed in an offset printer and employing in printing, multiple sheets of printed material can be obtained.

When it is desirable to obtain an even larger number of sheets of printed material, the method of exposing and developing by the usual method a photosensitive lithographic printing plate in which a sheet of a metal such as aluminum is employed as the support, and then reinforcing the image portion by high temperature heating (known as a "burning treatment") is effective. That is, the use of a burning treatment makes it possible to increase by several fold the number of sheets of printed material that can be obtained from a single lithographic printing plate relative to when a burning treatment is not conducted.

When printing with special printing inks containing numerous components that dissolve the image on the printing plate, such as inks cured by UV radiation and inks drying at low temperatures, with printing plates that have been fabricated by the usual method without being subjected to a burning treatment, the image portions undergo severe leaching out and the number of sheets that can be printed drops markedly relative to when common ink is employed. However, when a burning treatment is conducted, the solvent resistance of the image portion improves greatly so that an adequate number of sheets of printed material can be obtained even with special printing inks.

When conducting the burning treatment, hydrophobic organic materials that scatter by volatilization, sublimation, or the like from the image portion at elevated temperature adhere to the non-image portion (that is, the portion where the surface of the hydrophilic support is exposed by development), causing the non-image portion of the printing plate that was hydrophilic prior to the treatment to lose its hydrophilic property and generate grime when it receives printing ink. To prevent this, a surface treatment with a liquid containing an organic acid or a surfactant, described further below, is generally conducted between development and the burning treatment. The treatment with a surface-treatment liquid can be conducted in the gum-processing unit of a three-bath type autodeveloping unit comprising the steps of alkali development, water washing, and gumming by using the surface-treatment liquid in place of the gum solution and conducting treatment with the surface-treatment liquid immediately after development, or by accumulating in a stacker the plates that have been developed as they come out of the autodeveloping unit, and subjecting them to treatment with the surface-treatment liquid in another processing unit the next day or later prior to printing. In this manner, adhesion of the hydrophobic organic material to the non-image portion is prevented during the subsequent burning treatment.

Further, in the conventional process of fabricating lithographic printing plates, a step of dissolving away the unwanted photosensitive layer with developer or the like is required after exposure. Simplifying such wet processing that is additionally conducted is one problem to be resolved. In particular, out of concern for the global environment, the problems of the disposal of the waste solution that is discharged as part of high pH alkali development and volatile organic compounds (VOCs) contained in the developer have become a major concern of the industrial world as a whole in recent years. Thus, as one simplification, the desire to be able to develop with aqueous solutions that are close to neutral and that do not contain organic solvents has become even stronger. As a further simplification perspective, in conventional high pH alkali development systems, the three-bath processing system, in which the water-washing step for removing the developer that has adhered to the printing plate following development and the gumming step to protect the hydrophilic property of the non-image portion and render it insensitive to lipids are conducted after the developing step, has been the mainstream. However, interest in a single-bath processing system permitting reductions in the quantities of water and chemicals employed has been growing.

In recent years, digital technology for electronically processing, accumulating, and outputting image information by computer, has become widespread. Various new modes of image output corresponding to such digital technology have become practical. At the same time, the computer to plate (CTP) technique of loading digital image information onto a highly coherent beam, such as a laser beam, and exposing a lithographic printing plate precursor by scanning it with such a beam to directly fabricate a lithographic printing plate without an intervening lith film, has garnered considerable attention. Accordingly, obtaining a lithographic printing plate precursor that is suited to such techniques has become an important technical issue.

Solid-state lasers such as semiconductor lasers emitting infrared (IR) radiation with wavelengths of 760 to 1,200 nm and YAG lasers are extremely useful as the light sources of the lasers that are employed in the CTP technique due to the inexpensive availability of high-output, compact units. UV lasers can also be employed.

Given the background set forth above, adaptation to both the simplification and digitization of the plate manufacturing industry is now increasing, and is strongly desired.

In this regard, for example, the specification of European Patent 1,342,568 describes a method for manufacturing plates in which a presensitized planographic printing plate -- comprising a photosensitive layer of hydrophobic thermoplastic polymer particles dispersed in hydrophilic binder that is provided on a hydrophilic support -- is developed with a gum solution.

International publication WO 05/111727 describes a method of processing a lithographic printing plate precursor in which a lithographic printing plate precursor comprising (i) a hydrophilic support and (ii) a photosensitive layer containing a radical polymerizable ethylenic unsaturated monomer, radical polymerization initiator, and photosensitive pigment is exposed to an image with a violet laser, IR laser, or the like after which the uncured portion of the photosensitive layer is removed with a gum solution in a single-bath process.

International publication WO 07/057349 describes a method of fabricating plates in which a radical polymerization photosensitive layer is exposed to an image with a violet laser, IR laser, or the like, after which two gum solution developing units are employed in coupled fashion. A burning surface-treatment liquid is employed in a developing unit for development, followed in continuous fashion by burning processing.

U.S. Patent Application Publication 2010/0216067 describes a method of fabricating plates in which a radical polymerization photosensitive layer is cured by IR laser exposure, undeveloped portions are removed with a solvent-containing developer of less than pH 12 comprising an ampholytic surfactant of specified structure and benzyl alcohol, and burning is conducted.

Japanese Laid-Open Patent Publication (KOKAI) No. 2005-10675 describes a method of fabricating plates in which a radical polymerization photosensitive layer is cured by laser exposure and developed with an alkali, after which a surface treatment and burning are conducted without water washing.

### SUMMARY OF THE INVENTION

In the plate manufacturing method described in European Patent 1,342,568, the lithographic printing plate precursor is exposed to an image with an IR laser, forming an image by fusing hydrophobic thermoplastic polymer particles. Subsequently, a gum solution is used to remove the unexposed portion and develop the image.

Although extremely good developing properties are achieved by such methods of developing with a gum solution a lithographic printing plate precursor on which an image has been formed by thermally fusing microparticles, sensitivity and print resistance are poor. Further, there is a problem in that even when a plate that has been developed in a single bath with this technology is burned to enhance print resistance, the thermally fused microparticles that are carried off with the gum solution from undeveloped portions are not fully removed by the treatment with a surface-treatment liquid, and end up fusing to the non-image portion during the subsequent burning treatment, producing a marked deterioration in terms of the staining property.

Since the inventions described in International Publications WO 05/111727 and WO 07/057349 employ radical polymerization to form images, they afford high print durability and make it possible to greatly reduce the amount of water and chemicals employed by using a single-bath process. Although International Publication WO 07/057349 further discloses a burning treatment for achieving even higher print r durability, when a burning treatment is employed in these plate manufacturing methods, the problem of deterioration in terms of the staining property of the non-image portions sometimes remains.

In the invention described in US Patent Application 2010/0216067, higher print durability is achieved by using a binder polymer or the like of low water solubility or water dispersibility in the photosensitive layer. However, to remove the photosensitive layer by developer, an organic solvent is incorporated as a developing adjuvant. Perhaps for this reason, there are problems in that when the developer that is disclosed therein is employed in single-bath processing, the organic solvent remaining in the developer on non-image portions volatilizes, the components removed by developing precipitate out and adhere to the substrate, and the staining property during printing deteriorates. When a burning treatment is conducted, there is a problem in the form of marked deterioration of the staining property.

The invention described in Japanese Laid-Open Patent Publication (KOKAI) No. 2005-10675 discloses processing from treatment with a surface-treatment liquid through to burning processing without water washing following alkali development. However, the alkali-soluble binder that is carried off with the alkali developer is not completely removed by the treatment with the surface-treatment liquid, and the problem of deterioration of the staining property in non-image portions remains.

Accordingly, one object of the present invention is to provide a method for manufacturing lithographic printing plates with good print durability and a low print staining property, in which the content of organic solvents with a pH in the vicinity of neutral is small, the quantity of chemicals employed is low, the quantity of waste solution is small, and processing can be conducted in a single bath.

The means of solvent the above-stated problem are as set forth below.
[1] A method for manufacturing lithographic printing plates comprising
   (A) exposing to a negative-type lithographic printing plate precursor comprising an image-forming layer that is curable by exposure to light on a support having a hydrophilic surface;
   (B) developing with a developer having a pH of 4 to 10 the negative-type lithographic printing plate precursor that has been exposed;
   (C) treating with a burning surface-treatment liquid the negative-type lithographic printing plate precursor that has been developed; and
   (D) subjecting the negative-type lithographic printing plate precursor to a burning treatment; and
   by an interval between the developing (B) and the treating with a burning surface-treatment liquid (C) of from 1 minute or more to 10 hours or less, during which time no water-washing or gumming is incorporated.
[2] The method for manufacturing lithographic printing plates according to [1], wherein the interval between the developing (B) and the treating with a burning surface-treatment liquid (C) is from 2 minutes or more to 5 hours or less.
[3] The method for manufacturing lithographic printing plates according to [1], wherein the interval between the developing (B) and the treating with a burning surface-treatment liquid (C) is from 3 minutes or more to 3 hours or less.
[4] The method for manufacturing lithographic printing plates according to any one of [1] to [3], wherein the developer has a pH of 6 to 8.
[5] The method for manufacturing lithographic printing plates according to any one of [1] to [4], wherein the image-forming layer comprises at least one from among (i) an acrylic polymer having a monomer unit derived from a vinyl carbazole compound, and/or a urethane-acrylic hybrid polymer; (ii) butyral resin, and (iii) a hydrophobic precursor.
[6] The method for manufacturing lithographic printing plates according to any one of [1] to [4], wherein the image-forming layer comprises butyral resin.
[7] The method for manufacturing lithographic printing plates according to [6], wherein the butyral resin further comprises a monomer unit derived from a vinyl ester of trimellitic acid.
[8] The method for manufacturing lithographic printing plates according to any one of [1] to [4], wherein the image-forming layer comprises an acrylic polymer having a monomer unit derived from a vinyl carbazole compound, and/or a urethane-acrylic hybrid polymer.
[9] The method for manufacturing lithographic printing plates according to [8], wherein the acrylic polymer further comprises a monomer unit derived from acrylonitrile.
[10] The method for manufacturing lithographic printing plates according to [8], wherein the urethane-acrylic hybrid polymer comprises a monomer unit derived from a compound selected from the group consisting of diphenylmethane diisocyanate, m-tolylene diisocyanate, isophorone diisocyanate, and dichlorohexylmethane diisocyanate.
[11] The method for manufacturing lithographic printing plates according to any one of [1] to [4], wherein the image-forming layer comprises hydrophobic thermoplastic polymer microparticles.
[12] The method for manufacturing lithographic printing plates according to [11], wherein the hydrophobic thermoplastic polymer microparticles are comprised of a copolymer having monomer units derived from acrylonitrile and styrene.
[13] The method for manufacturing lithographic printing plates according to any one of [1] to [12], wherein the image-forming layer has sensitivity to light in a wavelength region of from 350 to 450 nm, and the exposing (A) is conducted by irradiating a violet laser beam.
[14] The method for manufacturing lithographic printing plates according to any one of [1] to [12], wherein the image-forming layer has sensitivity to light in a wavelength region of from 750 to 1,400 nm, and the exposing (A) is conducted by irradiating an infrared laser beam.

The present invention provides a method for manufacturing lithographic printing plates with good print durability and print staining properties, in which the content of organic solvents with pH levels close to neutral is small, the quantity of chemicals employed is low, the quantity of waste solution generated is small, and processing can be conducted in a single bath.

### BRIEF DESCRIPTION OF THE DRAWINGS

[Figure 1] A drawing showing the configuration of an example of an autodeveloping unit for single-bath processing that can be suitably employed in the method for manufacturing planographic printing plates of the present invention.
[Figure 2] A drawing showing the configuration of an example of an autodeveloping unit for three-bath processing that can be suitably employed in the method for manufacturing planographic printing plates of the present invention.
[Figure 3] A drawing showing the configuration of an example of an autodeveloping unit for single-bath processing that can be suitably employed in the method for manufacturing planographic printing plates of the present invention.
   - 11: Conveyance path
   - 200: Preheating section
   - 300: Developing section
   - 400: Drying section
   - 202: Unit frame
   - 204: Heating section
   - 208: Heating chamber
   - 210: Serial rollers
   - 212: Entrance
   - 214: Heater
   - 216: Circulating fan
   - 302: Insertion section
   - 304: Pair of insertion rollers
   - 306: Treatment tank
   - 306a: Edge of treatment tank
   - 308: Developing tank (filled with developer)
   - 310: Outer sheet panel
   - 312: Slit-shaped insertion opening
   - 316: Pair of rollers in liquid
   - 318: Pair of outward conveyance rollers
   - 322: Pair of brush rollers
   - 324: Shielding lid
   - 326: Pair of brush rollers
   - 330: Spray pipe (*Configured to feed developer in developing tank 308 that has been aspirated by a pump, not shown; developer is sprayed by spray pipe 330 into developing tank 308.
   - 334: Slit-shaped insertion opening
   - 336: Liquid temperature sensor
   - 338: Liquid level gauge
   - 332: Partition plate
   - 342: Guide member
   - 344: Guide roller
   - 402: Support roller
   - 404: Outlet
   - 406: Pair of conveying rollers
   - 408: Pair of conveying rollers
   - 410,412: Ducts
   - 414: Slit opening
   - 50: External tank (containing developer)
   - 51: Overflow port
   - 52: Upper limit liquid level gauge
   - 53: Lower level liquid level gauge
   - 54: Filter section
   - 55: Developer feed pump
   - C1: Primary circulation piping
   - C2: Secondary circulation piping
   - 71: Water replenishment tank (water reservoir)
   - 72: Water replenishment pump
   - C3: Water replenishment piping
   - 1: Automatic developing unit
   - 10: Development processing section
   - 12: Printing plate
   - 14: Developing section
   - 16: Water washing section
   - 18: Desensitization treatment section
   - 20: Drying section
   - 24: Development tank
   - 141, 142: Brush rollers (rubbing members)
   - 200: Pretreatment section
   - 61: Rotating brush roll
   - 62: Receiving roll
   - 63: Conveying roll
   - 64: Conveyance guide plate
   - 65: Spray pipe
   - 66: Piping
   - 67: Filter
   - 68: Plate feed base
   - 69: Plate discharge base
   - 70: Developer tank
   - 71: Circulation pump
   - 72: Plate

### BEST MODE FOR CARRYING OUT THE INVENTION

The method for manufacturing lithographic printing plates of the present invention is characterized:
by comprising
(A) exposing to a negative-type lithographic printing plate precursor comprising an image-forming layer that is curable by exposure to light on a support having a hydrophilic surface;
(B) developing with a developer having a pH of 4 to 10 the negative-type lithographic printing plate precursor that has been exposed;
(C) treating with a burning surface-treatment liquid the negative-type lithographic printing plate precursor that has been developed; and
(D) subjecting the negative-type lithographic printing plate precursor to a burning treatment; and
in that the time between the developing (B) and the treating with a burning surface-treatment liquid (C) is from 1 minute or more to 10 hours or less, during which time no water-washing or gumming is incorporated.

In the present specification, the "time between the developing and the treating with a burning surface-treatment liquid" refers to the period from when the image-forming layer of the unexposed portion is removed to when the burning surface-treatment liquid comes into contact with the lithographic printing plate.

The method for manufacturing lithographic printing plates of the present invention will be described in greater detail below. After describing the developing step, which is the most characteristics step in the present invention, the other steps and the like will be described.

In the present invention, statements of "lower limit to upper limit" denoting numerical ranges denote "not less than the lower limit, not more than the upper limit," and statements of "upper limit to lower limit" denotes "not more than the upper limit, not less than the lower limit." That is, they denote numerical ranges that include the upper limit and the lower limit.

In the present invention, unless specifically stated otherwise, the term "group" means both substituted or unsubstituted. For example, an "alkyl group" means not just an unsubstituted alkyl group, but also a substituted alkyl group.

### (A: The exposure step)

The method for manufacturing lithographic printing plates of the present invention includes a step of exposing to an image a negative-type lithographic printing plate precursor comprising an image-forming layer on a support having a hydrophilic surface (exposure step).

Prior to the developing step set forth further below, an exposure step is conducted. In the exposure step, the negative-type lithographic printing plate precursor obtained in the lithographic printing plate precursor manufacturing step is desirably exposed through a transparent original image comprising a linear image, halftone image, or the like, or is exposed to an image by being scanned with a laser beam based on digital data.

In the present invention, the term "image" can mean an image such as a graphic or photograph in a narrow sense, but also includes the concepts of characters, numbers, symbols, and the like. It also includes combinations thereof.

Examples of light sources that are suitable for exposure are carbon arc lamps, mercury lamps, xenon lamps, metal halide lamps, strobes, LEDs, and laser beams. Laser beams are preferred, such as solid state lasers and semiconductor lasers emitting 760 to 1,200 nm IR radiation, ultraviolet (UV) to visible light semiconductor lasers emitting 350 to 450 nm light, argon ion lasers emitting visible light, FD-YAG lasers, and violet lasers.

The light source desirably has a wavelength of 350 to 450 nm. Specifically, an InGaN semiconductor laser is desirable from the perspectives of wavelength characteristics and cost. The exposure mechanism can be of the internal drum type, external drum type, flatbed type, or the like. The laser described in Japanese Laid-Open Patent Publication (KOKAI) Heisei No. 2007-58170 can be employed as an available 350 to 450 nm laser light source.

From the perspective of simplifying plate manufacturing, it is desirable to employ a laser emitting IR radiation permitting operations to be conducted under white or yellow lamps. A red laser will desirably have an output of 100 mW or higher, desirably afford 20 µs or less of exposure time per pixel, and desirably generate an irradiation energy level of 10 to 300 mJ/cm. Multibeam laser devices are desirably employed to shorten the exposure time.

The constituent elements and components of a lithographic printing plate precursor that can be used in the present invention are described below.

### < Lithographic printing plate precursor >

The lithographic printing plate precursor employed in the present invention has a negative-type image forming capacity in which a region exposed to an image becomes an image portion that is cured and an unexposed region that is removed by developing as set forth above forms a non-image portion. In the present invention, the phrase "having an image-forming layer on a support" means that the image-forming layer can be provided in direct contact with the support, or other layers can be provided between the support and the image-forming layer. It does not preclude the presence of optional layers such as a protective layer, an undercoating layer, an intermediate layer, and a back coat layer on a lithographic printing plate precursor.

### (The image-forming layer)

Representative image-forming mechanisms of the image-forming layer of the lithographic printing plate precursor employed in the present invention are a form (1) comprising (A) a sensitizing dye, (B) a radical polymerization initiator, and (C) a polymer compound, in which an exposed region is cured by radical polymerization to form an image portion; and a form (2) comprising (A) a sensitizing dye and (D) a hydrophobic precursor, in which the hydrophobic precursor is thermally fused or thermally reacted to form a hydrophobic region (image portion). Forms (1) and (2) can also contain a binder polymer. These two forms can also be combined.

Of these, a form of the image-forming layer in which the radical polymerization image-forming layer of (1) contains (E) a binder polymer is desirable.

The various components contained in the image-forming layer will be sequentially described below.

### (A) The sensitizing dye

The image-forming layer of the present invention desirably comprises a sensitizing dye. The sensitizing dye that is employed is not specifically limited other than that it absorb light during image exposure, assume an excited state, and supply energy such as by transferring an electron, transferring energy, or generating heat that passes to the polymerization initiator, described further below, thereby enhancing the function of the polymerization initiator. In particular, a sensitizing dye having maximum absorption from 300 to 450 nm or from 750 to 1,400 nm is desirably employed.

The sensitizing dyes showing maximum absorption in the wavelength range from 350 to 450 nm include merocyanines, benzopyranes, coumarines, aromatic ketones, anthracenes, styryls, and oxazoles.

Among the sensitizing dyes showing maximum absorption in the wavelength range from 360 to 450 nm, preferable dyes are those represented by the formula (IX), from the viewpoint of large sensitivity.

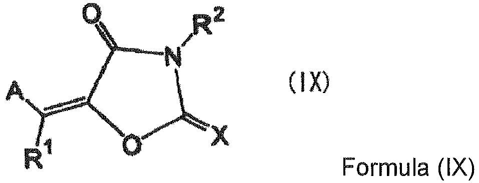

In the formula (IX), A represents an aryl group or heteroaryl group which may have a substituent group, and X represents an oxygen atom, sulfur atom or =N(R³). Each of R¹, R² and R³ independently represents a monovalent group of non-metallic atom, wherein A and R¹, or R² and R³, may combine respectively to form an aliphatic or aromatic ring.

The formula (IX) will now be further detailed. The monovalent group of non-metallic atom represented by R¹, R² or R³ is preferably a hydrogen atom, substituted or unsubstituted alkyl group, substituted or unsubstituted alkenyl group, substituted or unsubstituted aryl group, substituted or unsubstituted heteroaryl group, substituted or unsubstituted alkoxy group, substituted or unsubstituted alkylthio group, hydroxy group, and halogen atom.

The aryl group and heteroaryl group represented by A, which may have a substituent group, are same as the substituted or unsubstituted aryl group, and substituted or unsubstituted heteroaryl group represented respectively by R¹, R² and R³.

Specific examples of the sensitizing dye preferably used herein include the compounds described in paragraphs [0047] to [0053] of Japanese Laid-Open Patent Publication No. 2007-58170.

The sensitizing dyes denoted by general formulas (V) and (VI) below can also be employed.

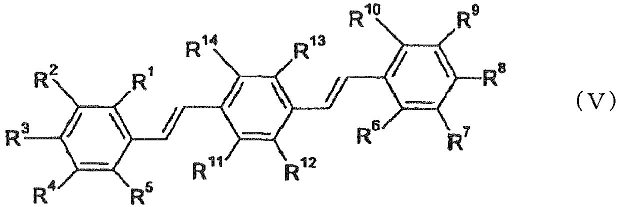

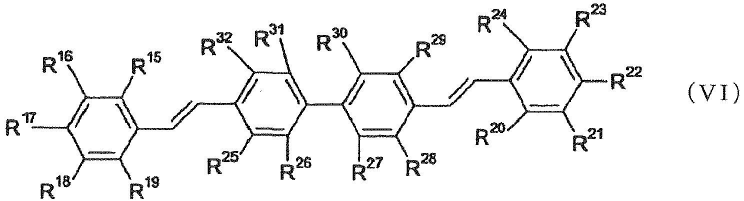

In formula (V), each of R¹ to R¹⁴ independently denotes a hydrogen atom, alkyl group, alkoxy group, cyano group, or halogen atom, with at least one from among R¹ to R¹⁰ denoting an alkoxy group with two or more carbon atoms.

In formula (VI), each of R¹⁵ to R³² independently denotes a hydrogen atom, alkyl group, alkoxy group, cyano group, or halogen atom, with at least one from among R¹⁵ to R²⁴ denoting an alkoxy group with two or more carbon atoms.

As specific examples of such sensitizing dyes, the compounds described in European Patent Application Publication 1,349,006 and WO 2005/029187 are desirably employed.

The sensitizing dyes described in Japanese Laid-Open Patent Publication (KOKAI) Nos. 2007-171406, 2007-206216, 2007-206217, 2007-225701, 2007-225702, 2007-316582, and 2007-328243 can also be employed.

Sensitizing dyes exhibiting maximum absorption at 750 to 1,400 nm that are suitably employed in the present invention (also sometimes referred to as "IR radiation-absorbing agents" hereinafter) will be described next. IR-absorbing agents in the forms of dyes or pigments are desirably employed.

Commercially available dyes and known dyes described in the literature, such as in the "Handbook of Dyes" (compiled by the Society of Synthetic Organic Chemistry of Japan, 1970), can be employed. Specific examples are azo dyes, metal complex azo dyes, pyrazolone azo dyes, naphthoquinone dyes, anthraquinone dyes, phthalocyanine dyes, carbonium dyes, quinoneimine dyes, methine dyes, cyanine dyes, squarylium dyes, pyrylium salts, and metal thiolate complexes.

Of these dyes, the cyanine dyes, squarylium dyes, pyrylium salts, nickel thiolate complexes, and indolenine cyanine dyes are preferred. The cyanine dyes and indolenine cyanine dyes are of greater preference, and the cyanine dye denoted by formula (a) below is a particularly preferred example.
formula (a)

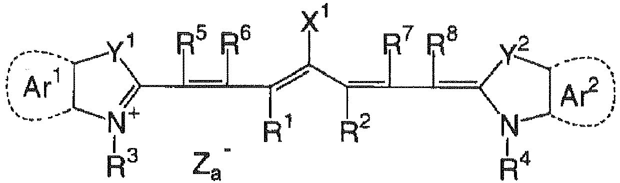

In formula (a), X¹ denotes a hydrogen atom, halogen atom, -NPh₂, X²-L¹, or the group denoted below. Here, X² denotes an oxygen atom, nitrogen atom, or sulfur atom; L¹ denotes a hydrocarbon group with 1 to 12 carbon atoms, aromatic ring comprising hetero atoms (N, S, O, halogen atom, Se), or a hydrocarbon group with 1 to 12 carbon atoms comprising hetero atoms. Xₐ⁻ is defined identically with Zₐ⁻, described further below. R^{a} denotes a substituent selected from among a halogen atom, substituted or unsubstituted amino group, aryl group, alkyl group, or hydrogen atom.

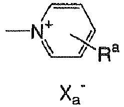

Each of R¹ and R² independently denotes a hydrocarbon group with 1 to 12 carbon atoms. Taking into account the storage stability of the image-forming layer coating liquid, R¹ and R² desirably denote hydrocarbon groups with 2 or more carbon atoms. R¹ and R² are preferably bonded together to form a five or six-membered ring.

Ar¹ and Ar², which may be identical or different, denote optionally substituted aromatic hydrocarbon groups. Desirable examples of aromatic hydrocarbon groups are benzene rings and phthalene rings. Examples of desirable substituents are hydrocarbon groups with not more than 12 carbon atoms, halogen atoms, and alkoxy groups with not more than 12 carbon atoms. Y¹ and Y², which may be identical or different, denote sulfur atoms or dialkylmethylene groups with not more than 12 carbon atoms. R³ and R⁴, which may be identical or different, denote optionally substituted hydrocarbon groups with not more than 20 carbon atoms. Examples of desirable substituents are alkoxy groups with not more than 12 carbon atoms, carboxyl groups, and sulfo groups. Each of R⁵, R⁶, R⁷, and R⁸, which may be identical or different, denotes a hydrogen atom or a hydrocarbon group with not more than 12 carbon atoms. Due to starting material availability, hydrogen atom is desirable. Zₐ⁻ denotes a counter anion. However, when the cyanine dye denoted by formula (a) comprises an anionic substituent within the structure thereof and a neutral charge is unnecessary, Zₐ⁻ is unnecessary. Due to the storage stability of the image-forming layer coating liquid, Zₐ⁻ is desirably a halogen ion, perchloric acid ion, tetrafluoroborate ion, hexafluorophosphate ion, or sulfonic acid ion, and preferably a perfluoric acid ion, hexafluorophosphate ion, or aryl sulfonate ion. It preferably does not contain a halogen atom as a counterion.

Specific examples of cyanine dyes denoted by formula (a) that are suitable for use are those described in paragraphs [0017] to [0019] in Japanese Laid-Open Patent Publication (KOKAI) No. 2001-133969.

Additional preferred examples are the specific indolenine cyanine dyes described in Japanese Laid-Open Patent Publication (KOKAI) No. 2002-278057.

Commercially available pigments and the pigments described in the Color Index (C.I.) Handbook; "Most Recent Pigment Handbook," (Japan Society of Colour Material, 1977); "Most Recent Pigment Application Techniques," (published by CMC, 1986), and "Printing Ink Techniques" (published by CMC, 1984) can be employed as pigments.

These photosensitizing dyes are desirably added in quantities of 0.05 to 30 weight parts, preferably 0.1 to 20 weight parts, and optimally, within a range of 0.2 to 10 weight parts per 100 weight parts of the total solid component of the image-forming layer. (B) The polymerization initiator

The image-forming layer in the present invention contains a polymerization initiator (also referred to as an "initiator compound" hereinafter). A radical polymerization initiator is desirably employed in the present invention.

The initiator compound may be arbitrarily selected from compounds known among those skilled in the art without limitation. Specific examples include trihalomethyl compound, carbonyl compound, organic peroxide, azo compound, azide compound, metallocene compound, hexaarylbiimidazole compound, organic boron compound, disulfone compound, oxim ester compound, onium salt, and iron arene complex. In particular, the initiator compound is preferably at least one species selected from the group consisting of hexaarylbiimidazole compound, onium salt, trihalomethyl compound and metallocene compound, and is particularly hexaarylbiimidazole compound. Two or more species of them may be used in combination as the polymerization initiator.

Hexaarylbiimidazole compounds include the lophine dimers described in Japanese Examined Patent Publication (KOKOKU) Showa Nos. 45-37377 and 44-86516, such as 2,2'-bis(o-chlorophenyl)-4,4',5,5'-tetraphenylbiimidazole, 2,2'-bis(o-bromophenyl)-4,4',5,5'-tetraphenylbiimidazole, 2,2'-bis(o,p-dichlorophenyl)-4,4',5,5'-tetraphenylbiimidazole, 2,2'-bis(o-chlorophenyl)-4,4',5,5'-tetra(m-methoxyphenyl)biimidazole, 2,2'-bis(o,o'-dichlorophenyl)-4,4',5,5'-tetraphenylbiimidazole, 2,2'-bis(o-nitrophenyl)-4,4',5,5'-tetraphenylbiimidazole, 2,2'-bis(o-methylphenyl)-4,4',5,5'-tetraphenylbiimidazole, and 2,2'-bis(o-trifluorophenyl)-4,4',5,5'-tetraphenylbiimidazole.

The hexaarylbiimidazole compounds are desirably employed in combination with sensitizing dyes having maximum absorption at 300 to 450 nm.

Sulfonium salt, iodonium salt, and diazonium salt are desirably employed among the onium salts that can be suitably employed in the present invention. Diaryliodonium salts and triaryliodonium salts are preferably employed. An onium salt is preferably employed in combination with an IR-absorbing agent having maximum absorption at 750 to 1,400 nm.

The polymerization initiators described in paragraphs [0017] to [0129] in Japanese Laid-Open Patent Publication (KOKAI) No. 2007-206217 are also desirably employed as polymerization initiators.

A single polymerization initiator can be suitably employed, or two or more can be combined for use in the present invention.

The quantity of polymerization initiator employed in the image-forming layer in the present invention is desirably 0.01 to 20 weight%, preferably 0.1 to 15 weight%, and more preferably, 1.0 to 10 weight% relative to the weight of the total solid component of the image-forming layer. (C) Polymerizable Compound

The polymerizable compound used for the image recording layer is an addition polymerizable compound having at least one ethylenic unsaturated double bond, and is selected from compounds having at least one, and preferably two, terminal ethylenic unsaturated bonds. These compounds typically have any of chemical forms including monomer; prepolymer such as dimer, trimer and oligomer; and mixtures of them. Examples of the monomer include unsaturated carboxylic acid (for example, acrylic acid, methacrylic acid, itaconic acid, crotonic acid, isocrotonic acid, maleic acid), esters of them, and amides of them. More preferable examples include esters formed between unsaturated carboxylic acid and polyhydric alcohol compound, and amides formed between unsaturated carboxylic acid and polyvalent amine compound. Still other preferable examples include adducts of unsaturated carboxylate esters or amides having nucleophilic substituent group such as hydroxy group, amino group, mercapto group or the like, formed together with monofunctional or polyfunctional isocyanates or epoxys; and dehydration condensation product formed together with monofunctional or polyfunctional carboxylic acid. Still other preferable examples include adducts of unsaturated carboxylate esters or amides having electrophilic substituent group such as isocyanate group and epoxy group, formed together with monofunctional or polyfunctional alcohols, amines, or thiols; and substitution products of unsaturated carboxylate esters or amides having eliminative substituent group such as halogen group and tosyloxy group, formed together with monofunctional or polyfunctional alcohols, amines, or thiols.

Specific examples of the monomer in the form of acrylate ester formed between polyhydric alcohol compound and unsaturated carboxylic acid include ethylene glycol diacrylate, 1,3-butanediol diacrylate, tetramethylene glycol diacrylate, propylene glycol diacrylate, trimethylolpropane triacrylate, hexanediol diacrylate, tetraethylene glycol diacrylate, pentaerythritol tetraacrylate, sorbitol triacrylate, isocyanurate ethylene oxide (EO)-modified triacrylate, and polyester acrylate oligomer. Examples of methacrylate ester include tetramethylene glycol dimethacrylate, neopentyl glycol dimethacrylate, trimethylolpropane trimethacrylate, ethylene glycol dimethacrylate, pentaerythritol trimethacrylate, bis[p-(3-methacryl oxy-2-hydroxypropoxy)phenyl]dimethylmethane, and bis-[p-(methacryloxyethoxy)phenyl]dimethylmethane. Specific examples of the monomer in the form of amide formed between polyvalent amine compound and unsaturated carboxylic acid include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide, and xylylene bismethacrylamide.
Also urethane-based addition polymerizable compound, obtainable by addition polymerization between the isocyanate and hydroxy group, is preferable. Preferable examples of this sort of compound include vinyl urethane compound having two or more polymerizable vinyl groups per one molecule, which is obtainable by addition reaction between a vinyl monomer having a hydroxy group represented by the formula (A) below, and a polyisocyanate compound having two or more isocyanate groups per one molecule, as described in Examined Japanese Patent Publication No. S48-41708.

CH₂=C(R⁴)COOCH₂CH(R⁵)OH (A)

(where, each of R⁴ and R⁵ represents H or CH₃.)

Further, urethane acrylates such as those described in Japanese Laid-Open Patent Publication (KOKAI) Showa No. 51-37193 and Japanese Examined Patent Publication (KOKOKU) Heisei Nos. 2-32293 and 2-16765; and the ethylene oxide skeleton-comprising urethane compounds described in Japanese Examined Patent Publication (KOKOKU) Showa Nos. 58-49860, 56-17654, 62-39417, and 62-39418 are also suitable.

The polymerizable compound capable of photooxidation described in Published Japanese Translation (TOKUHYO) No. 2007-506125 of a PCT International Application is also suitable. A polymerizable compound comprising at least one urea group and/or a tertiary amine group is preferred. The following compound is a specific example.

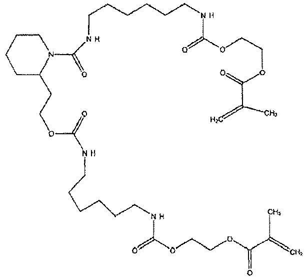

The particulars regarding the use methods of these polymerizable compounds, such as their structures, whether they are used singly or in combination, and the quantities added, can be set as desired in accordance with the final performance design of the lithographic printing plate precursor. These polymerizable compounds are desirably employed in a quantity of 5 to 75 weight%, preferably 25 to 70 weight%, and more preferably, within a range of 30 to 60 weight% relative to the total solid component of the image-forming layer.

The other useful form (2) of the image-forming layer of the present invention comprising (A) a sensitizing dye and (D) a hydrophobic precursor will be described here with regard to the (D) hydrophobic precursor employed.

### < (D) The hydrophobic precursor >

An example of the hydrophobic precursor in the present invention is a microparticle that can render the image-forming layer hydrophobic when heated. At least one particle selected from among hydrophobic thermoplastic polymer microparticles and thermal reactive polymer microparticles is desirable as the microparticle, with hydrophobic thermoplastic polymer microparticles being preferred.

The specific mechanism is unclear. However, incorporating hydrophobic thermoplastic polymer microparticles into the image-forming layer and conducting a treatment with a burning surface-treatment liquid within one minute or more to 10 hours of development (desirably within 2 minutes or more but not more than 5 hours and preferably within 3 minutes or more but not more than 3 hours) causes components that have been removed by development not to re-adhere to the plate surface and prevents fixation of hydrophobic organic material during burning. Even when conducting a burning treatment on a plate that is to be highly resistant to printing, a considerable effect is achieved in reducing the quantity of water and chemicals employed and treatment with a single solution is possible.

Examples of hydrophobic thermoplastic polymer microparticles that can be suitably employed in the image-forming layer are the hydrophobic thermoplastic polymer microparticles described in Research Disclosure No. 33303 of January, 1992; Japanese Laid-Open Patent Publication (KOKAI) Heisei Nos. 9-123387, 9-131850, 9-171249, and 9-171250; and European Patent 931647.

Specific examples of the polymers constituting such polymer microparticles are homopolymers and copolymers of monomers such as ethylene, styrene, vinyl chloride, methyl acrylate, ethyl acrylate, methyl methacrylate, ethyl methacrylate, vinylidene chloride, acrylonitrile, and vinyl carbamoyl, and mixtures thereof. Of these, polystyrene, polymethyl methacrylate, and acrylonitrile are preferred.

The maximum value of the particle size distribution of the hydrophobic thermoplastic polymer microparticles are preferably 0.01 to 2.0 µm.

Examples of methods of synthesizing hydrophobic thermoplastic polymer microparticles in which the maximum value of the particle size distribution of the particles employed as the hydrophobic precursor is 0.01 to 2.0 µm are emulsion polymerization and suspension polymerization. Additionally, there is also a method in which these compounds are dissolved in a non-water-soluble organic solvent, the solution is mixed and emulsified with an aqueous solution containing a dispersing agent, and heat is applied to solidify the microparticulate form while removing the organic solvent (the dissolution dispersion method).

Examples of thermal reactivity polymer microparticles employed as the hydrophobic precursor in the present invention are polymer microparticles comprised of thermosetting polymer microparticles and thermal reactivity groups. They crosslink when they undergo a thermal reaction, and changes in the functional group during that process form a hydrophobic region.

Examples of thermosetting polymers are resins having phenol skeletons, urea resins (for example, urea and urea derivatives such as methoxymethylated urea that have been resinified with an aldehyde such as formaldehyde), melamine resins (for example, melamine or a derivative thereof that has been resinified with an aldehyde such as formaldehyde), alkyd resins, unsaturated polyester resins, polyurethane resins, and epoxy resins. Of these, resins with phenol skeletons, melamine resins, urea resins, and epoxy resins are preferred.

Examples of suitable resins having phenol skeletons are phenol resins obtained by resinifying phenol, cresol, or the like with an aldehyde such as formaldehyde, hydroxystyrene resins, N-(p-hydroxyphenyl)methacrylamide, p-hydroxyphenyl methacrylate, and other phenol skeleton-comprising methacrylamide, acrylamide, methacrylate, and acrylate polymers and copolymers.

The maximum value of the particle size distribution of the thermosetting polymer microparticles employed in the present invention is desirably 0.01 to 2.0 µm.

Such thermosetting polymer microparticles can be readily obtained by known dissolution and dispersion methods. It is also possible to prepare a thermosetting polymer in the form of microparticles during synthesis. The methods of manufacturing thermosetting polymer microparticles are not limited to those given above; known methods can be suitably adopted.

The thermal reactivity group in the polymer microparticle having a thermal reactivity group that is employed in the present invention can be any functional group undergoing a reaction that forms a chemical bond. Suitable examples are ethylenic unsaturated groups that undergo radical polymerization reactions (such as acryloyl groups, methacryloyl groups, vinyl groups, and allyl groups), cation polymerizable groups (such as vinyl groups and vinyloxy groups), isocyanate groups and blocks thereof undergoing addition reactions, epoxy groups, vinyloxy groups, and groups that react with them in the form of functional groups having active hydrogen atoms (such as amino groups, hydroxy groups, and carboxyl groups), carboxyl groups undergoing condensation reactions and groups that react with them in the form of hydroxy groups and amino groups, acid anhydrides undergoing ring-opening addition reactions and groups reacting with them in the form of amino groups and hydroxy groups.

These functional groups can be introduced into the polymer microparticles during polymerization or using a high polymer reaction following polymerization.

When incorporated during polymerization, the monomer having the functional group is desirably emulsion polymerized or suspension polymerized. Specific examples of the monomer having a functional group are: allyl methacrylate, allyl acrylate, vinyl methacrylate, vinyl acrylate, 2-(vinyloxy)ethyl methacrylate, p-vinyloxystyrene, p-(2-(vinyloxy)ethyl)styrene, glycidyl methacrylate, glycidyl acrylate, 2-isocyanate ethyl methacrylate, block isocyanates thereof based on alcohols and the like, 2-aminoethyl methacrylate, 2-aminoethyl acrylate, 2-hydroxyethyl methacrylate, 2-hydroxyethyl acrylate, acrylic acid, methacrylic acid, maleic anhydride, bifunctional acrylate, and bifunctional methacrylate. There is no limitation to these monomers.

In the present invention, copolymers of these monomers and monomers that will copolymerize with these monomers but that do not have thermally reactive groups can be employed with these monomers. Examples of copolymerizable monomers that do not have thermally reactive groups are styrene, alkyl acrylate, alkyl methacrylate, acrylonitrile, and vinyl acetate. Any monomer that does not have a thermally reactive group will do, and there is no limitation to the examples given.

An example of a high polymer reaction that is employed when introducing the thermally reactive group following polymerization is the high polymer reaction described in International Publication WO 96/34316.

Among the polymer microparticles having thermally reactive groups, those in which the polymer microparticles associate in the presence of heat are desirable. Those with hydrophilic surfaces that disperse in water are preferred. The contact angle (airborne water droplet) of a film that is prepared by coating just the polymer microparticles and conducting drying at a temperature lower than the solidification temperature is desirably smaller than the contact angle (airborne water droplet) of a film that is prepared by drying at a temperature higher than the solidification temperature. The surface of such a polymer microparticle can be rendered hydrophilic by causing a hydrophilic polymer or oligomer such as a polyvinyl alcohol or polyethylene glycol, or a hydrophilic low molecular weight compound to adsorb to the surface of the polymer microparticle. However, the method of rendering the surface hydrophilic is not limited thereto.

The solidification temperature of the polymer microparticle having the thermally reactive group is desirably 70°C or higher, and when stability over time is taken into account, preferably 100°C or higher. The maximum value of the particle size distribution of the polymer microparticle is desirably 0.01 to 2.0 µm, preferably 0.05 to 2.0 µm, and optimally, 0.1 to 1.0 µm. Within this range, good resolution and stability overtime are achieved.

The content of the hydrophobic precursor desirably falls within a range of 5 to 90 weight% of the solid component concentration. Its addition enhances the strength of the image portion.

### (E) The binder polymer

The image-forming layer of the present invention desirably comprises a binder polymer. A binder polymer that is capable of supporting the image-forming layer components on the support and that can be removed by the developer is employed. A binder polymer can be employed in the form of a (meth)acrylic polymer, polyurethane resin, polyvinyl alcohol resin, polyvinyl butyral resin, polyvinyl formal resin, polyamide resin, polyester resin, epoxy resin, or the like. (Meth)acrylic polymers, polyurethane resins, and polyvinyl butyral resins are preferred.

The image-forming layer of the present invention desirably comprises at least: one from among (i) an acrylic polymer comprising a monomer unit derived from a vinyl carbazole compound and/or an urethane-acrylic hybrid polymer; (ii) butyral resin; and (iii) a hydrophobic precursor.

In the present invention, the term "(meth)acrylic polymer" refers to a copolymer comprising a polymerization component in the form of a (meth)acrylic acid derivative such as (meth)acrylic acid, a (meth)acrylic acid ester (such as an alkyl ester, aryl ester, or allyl ester), a (meth)acrylamide, or a (meth)acrylamide derivative. The term "polyurethane resin" refers to a polymer produced by the condensation reaction of a compound having two or more isocyanate groups and a compound having two or more hydroxyl groups.

The term "polyvinyl butyral resin" refers to a polymer synthesized by reacting (acetylating) a polyvinyl alcohol, obtained by partially or fully saponifying polyvinyl acetate, with butyl aldehyde under acidic conditions, and includes polymers into which have been incorporated acid groups and the like by methods such as reaction with compounds having residual hydroxy groups, acid groups, and the like.

### <The polyvinyl butyral resin>

In the present invention, a butyral resin such as that indicated below is desirably employed. Among these, a polyvinyl butyral resin into which an acid group has been incorporated is optimally employed. The specific mechanism is not clear. However, by incorporating butyral resin into the image-forming layer and conducting a treatment with a burning surface-treatment liquid within 1 minute or more but not more than 10 hours (desirably within 2 minutes or more but not more than 5 hours, preferably within 3 minutes or more but not more than 3 hours) after development causes components that have been removed by development not to re-adhere to the plate surface and prevents fixation of hydrophobic organic material during burning. Even when conducting a burning treatment on a plate that is to be highly resistant to printing, a considerable effect is achieved in reducing the quantity of water and chemicals employed and treatment with a single solution is possible.

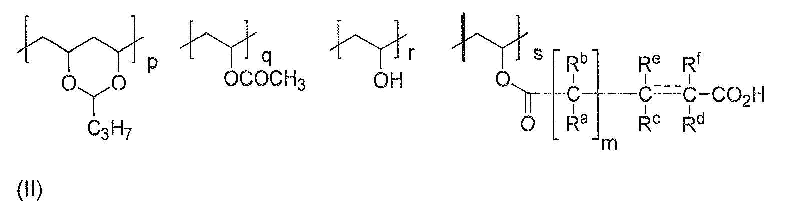

In formula (II), the desirable ratio of the ranges of the various repeating units is p/q/r/s = 50 to 78 mol%/1 to 5 mol%/5 to 28 mol%/5 to 20 mol%. Each of R^{a}, R^{b}, R^{c}, R^{d}, R^{e}, and R^{f} independently denotes an optionally substituted monovalent substituent or single bond. m denotes an integer of 0 or 1.

Examples of desirable substituents denoted by R^{a}, R^{b}, R^{c}, R^{d}, R^{e}, and R^{f} are hydrogen atoms, optionally substituted alkyl groups, halogen atoms, and optionally substituted aryl groups. Preferred examples are hydrogen atoms, methyl groups, ethyl groups, propyl groups, and other linear alkyl groups, carboxylic acid-substituted alkyl groups, halogen atoms, phenyl groups, and carboxylic acid-substituted phenyl groups. R^{c} and R^{d} as well as R^{e} and R^{f} can form ring structures, respectively. The bond between carbon atom bonding R^{c} and R^{e} and the carbon atom bonding R^{d} and R^{f} can be a single bond, double bond, or aromatic double bond. When it is a double bond or an aromatic double bound, R^{c} - R^{d}, R^{e} - R^{f}, R^{c} - R^{f}, or R^{e} - R^{d} are bonded together in a single bond.

Desirable specific examples of the above carboxylic acid group-comprising unit are given below. Of these, a vinyl ester of trimellitic acid is optimal.

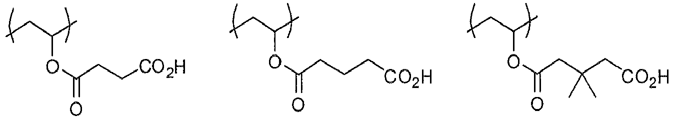

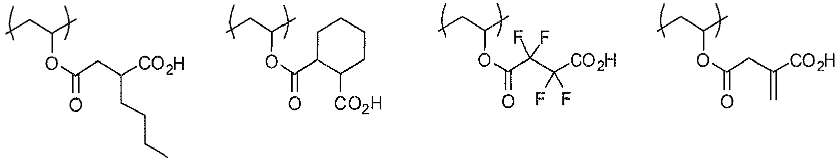

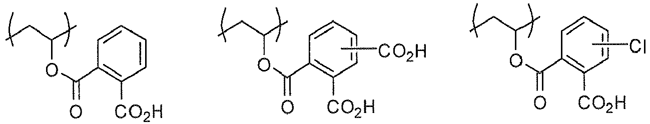

Another desirable example of the binder polymer in the present invention is a copolymer having a repeating unit comprising an acid group. Examples of the acid group are carboxylic acid groups, sulfonic acid groups, phosphonic acid groups, phosphoric acid groups, and sulfonamide groups. Carboxylic acid groups are preferred, and (meth)acrylic acid-derived repeating units and the repeating unit denoted by formula (I) below are desirably employed. 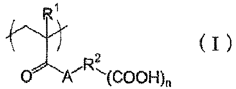 (In formula (I), R¹ denotes a hydrogen atom or a methyl group; R² denotes a single bond or a linking group of valence n+1. A denotes an oxygen atom or -NR³-, R³ denotes a hydrogen atom or a monovalent hydrocarbon with 1 to 10 carbon atoms. n denotes an integer of from 1 to 5.)

The linking group denoted by R² in formula (I) is comprised of hydrogen atoms, oxygen atoms, nitrogen atoms, sulfur atoms, and halogen atoms. The number of atoms desirably ranges from 1 to 80. Specific examples are an alkylene, substituted alkylene, arylene, and substituted arylene. These divalent groups can have structures that are bonded by multiple amide bonds and ester bonds. R² desirably denotes a single bond, alkylene, or substituted alkylene; preferably denotes a single bond, alkylene with 1 to 5 carbon atoms, or substituted alkylene with 1 to 5 carbon atoms; and optimally denotes a single bond, alkylene with 1 to 3 carbon atoms, or substituted alkylene with 1 to 3 carbon atoms.

Examples of the substituent are a monovalent non-metal atom group other than hydrogen, such as a halogen atom (-F, -Br, -Cl, -I), hydroxyl group, alkoxy group, aryloxy group, mercapto group, acyl group, carboxyl group, conjugate base group thereof, alkoxycarbonyl group, aryloxycarbonyl group, carbamoyl group, aryl group, alkenyl group, and alkynyl group.

R³ desirably denotes a hydrogen atom or a hydrocarbon group with 1 to 5 carbon atoms, preferably denotes a hydrogen atom or a hydrocarbon group with 1 to 3 carbon atoms, and optimally denotes a hydrogen atom or a methyl group. n is desirably 1 to 3, preferably 1 or 2, and optimally, 1.

From the perspective of the development property, the proportion (mol%) of the total copolymer component of the binder polymer accounted for by the copolymer component comprising a carboxylic acid group is desirably 1 to 70%. Taking into account achieving both a good development property and resistance to printing, it is preferably 1 to 50%, and more preferably, 1 to 30%.

In a further suitable example of the binder polymer in the present invention, the acid group of the polymer comprising an acid group can be neutralized by a basic compound, and in particular, is desirably neutralized by a compound comprising basic nitrogen, such as an amine group, amidine group, or guanidine group. The compound comprising basic nitrogen desirably comprises an ethylenic unsaturated group. Specific examples are the compounds described in WO 2007/057442.

The content of the polyvinyl butyral resin is desirably 5 to 70 weight%, preferably 15 to 50 weight percent, relative to the total solid component of the image-forming layer.

### <The acrylic polymer>

The image-forming layer of the present invention preferably comprises one or more acrylic polymers (vinyl carbazole polymers) having monomer units derived from vinyl carbazole compounds and/or urethane-acrylic hybrid polymers. The specific mechanism is not clear. However, incorporating these polymers into the image-forming layer and conducting a treatment with a burning surface-treatment liquid within 1 minute or more but not more than 10 hours (desirably within 2 minutes or more but not more than 5 hours, preferably within 3 minutes or more but not more than 3 hours) after development causes components that have been removed by development not to re-adhere to the plate surface and prevents fixation of hydrophobic organic material during burning. Even when conducting a burning treatment on a plate that is to be highly resistant to printing, a considerable effect is achieved in reducing the quantity of water and chemicals employed and treatment with a single solution is possible.

So long as the vinyl carbazole polymer comprises a monomer unit derived from vinyl carbazole (N-vinyl carbazole), the remaining repeating units can be any monomer. Specifically, one comprising a structural repeating unit derived from one or more from among (meth)acrylic acid, (meth)acrylic acid ester ((meth)acrylate), acrylonitrile, styrene, styrene derivatives, and poly(alkyleneglycol) (meth)acrylates is preferred. Of these, a polymer further containing a monomer unit derived from acrylonitrile is of greater preference. Still further, the polymer is more preferably an acrylic polymer (also referred to as an "acrylic resin"). The term "acrylic polymer" is a polymer obtained by copolymerizing or homopolymerizing a (meth)acrylate compound.

The content of the monomer unit derived from vinyl carbazole in the vinyl carbazole polymer is desirably 2 to 50 mol%, preferably 5 to 30 mol%, and more preferably, 8 to 15 mol% of the total polymer units.

The weight average molecular weight of vinyl carbazole polymers that can be employed in the present invention is desirably 2,000 to 1,000,000, preferably 10,000 to 200,000. The acid number (mgKOH/g) of the vinyl carbazole polymer is desirably 20 to 400 as determined by the usual method.

The content of the vinyl carbazole polymer is desirably 10 to 70 weight%, preferably 20 to 50 weight%, relative to the total solid component of the image-forming layer.

### <The urethane-acrylic hybrid polymer>

A uniformly dispersed urethane-acrylic hybrid polymer is desirably contained in the image-forming layer. The hybrid polymer is also desirably in particle form. The weight average molecular weight of the hybrid polymer is desirably 50,000 to 500,000. The mean diameter of the surface area distribution of the particles is desirably 10 to 10,000 nm, preferably 100 to 1,000 nm, and more preferably, 300 to 500 nm.

The hybrid polymer may be aromatic or aliphatic based on the structure of the manufacturing starting material. Two or more urethane-acrylic hybrid polymer particles may be mixed for use. For example, a Hybridur 570 polymer dispersion and Hybridur 870 polymer dispersion can be mixed for use.

Urethane-acrylic hybrid polymers that can be employed in the present invention can generally be prepared as follows. First, a polyol is reacted with an excess of diisocyanate to obtain a polyurethane prepolymer aqueous dispersion. The prepolymer desirably comprises a carboxy group. Next, the prepolymer is mixed with one or more vinyl monomers such as an acrylate monomer or substituted/unsubstituted styrene monomer. A tertiary amine is then added and the mixture is dispersed in water. To the aqueous dispersion is added a liposoluble initiator to initiate polymerization, yielding a hybrid polymer dispersed in water in colloidal particle form. The dispersion is not simply a mixture of a polyurethane dispersion and an acrylic emulsion, but is one in which the polymerization of the urethane and acrylic has taken place and been completed simultaneously. These urethane-acrylic hybrid polymer particles are desirably stably dispersed by a negative charge.

As is described in US Patent 3,684,758, the method of first preparing a polyurethane dispersion and then adding an acrylic monomer in the presence thereof to form an acrylic polymer is also useful for obtaining an urethane-acrylic hybrid polymer dispersion.

As a separate method, a urethane polymer and an acrylic monomer are dispersed together in water so that the urethane condensation polymerization reaction and acrylic polymerization advance simultaneously. For example, this is described in US Patents 4,644,030 and 5,173,526.

Details regarding additional manufacturing methods and physical properties of urethane-acrylic hybrid polymers are given in Galgoci et al., JCT Coatings Tech., 2(13), 28-36 (February 2005).

The urethane-acrylic hybrid polymer that can be employed in the present invention, particularly the diisocyanate compound that is employed as a starting material of the urethane, is preferably diphenylmethane diisocyanate, m-tolylene diisocyanate, isophorone diisocyanate, or dichlorohexylmethane diisocyanate. That is, the urethane-acrylic hybrid polymer preferably comprises a monomer unit derived from a compound selected from the group consisting of diphenylmethane diisocyanate, m-tolylene diisocyanate, isophorone diisocyanate, and dichlorohexylmethane diisocyanate.

The urethane-acrylic hybrid polymer that is desirably employed in the present invention can be procured as a commercial product in the form of a urethane-acrylic hybrid polymer particle dispersion such as Hybridur 540, 560, 570, 580, 870, 878, and 880 from Air Products and Chemicals, Inc. (Allentown, Pennsylvania). Generally, these dispersions contain the urethane-acrylic hybrid polymer as a solid component constituting at least 30 weight% thereof. They are dispersed in suitable aqueous media that can contain surfactants, antifoaming agents, dispersing agents, and preservatives that are readily available as commercial products, as well as additional pigments and water-dispersible organic solvents.

The urethane-acrylic hybrid polymer desirably constitutes 10 to 70 weight%, preferably 10 to 50 weight%, of the total solid component of the image-forming layer.

The binder-polymer that is useful in the present invention comprises a hydrophobic skeleton; examples are those containing the structural repeating unit of a) and b) below or containing the structural repeating unit of b).
a) a repeating unit having a pendant cyano group directly bonded to a hydrophobic skeleton, and
b) a repeating unit having a pendant group comprising a poly(alkyleneoxide) segment.

These binder polymers contain poly(alkyleneoxide) segments, desirably poly(ethyleneoxide) segments. These binder polymers can be graft polymers comprising a main chain polymer and a poly(alkyleneoxide) side chain, or block copolymers comprising blocks of (alkyleneoxide)-containing structural repeating units and blocks of non(alkyleneoxide)-containing repeating units. Both graft polymers and block polymers can further comprise pendant cyano groups directly bonded to the hydrophobic skeleton. The alkyleneoxide structural unit is desirably an alkyleneoxide group with 1 to 6 carbon atoms, preferably an alkyleneoxide group with 1 to 3 carbon atoms. The alkylene moiety can be linear or branched, or be a substitution product thereof. Poly(ethyleneoxide) and poly(propyleneoxide) segments are desirable and poly(ethyleneoxide) segments are optimal.

Depending on the implementation mode, the binder polymer can contain just a structural repeating unit comprising a poly(alkyleneoxide) segment. In other implementation modes, the polymer binder can comprise structural repeating units containing poly(alkyleneoxide) segments and structural repeating units having pendant cyano groups directly bonded to the hydrophobic skeleton. As an example, the structural repeating unit can contain a pendant group comprising a cyano, cyano-substituted, or cyano-terminated alkylene group. The repeating unit can be derived from an ethylenic unsaturated monomer such as acrylonitrile, methacrylonitrile, methyl cyanoacrylate, ethyl cyanoacrylate, or a combination thereof. However, the cyano group can also be introduced into the polymer by other conventional means. An example of a cyano group-containing binder polymer is described in US Patent Application Publication 2005/003285.

As an example, the binder polymer can be formed by polymerizing a mixture obtained by combining the following suitable ethylenic unsaturated monomers and macromers:
A) Acrylonitrile, methacrylonitrile, and combinations thereof;
B) A poly(alkyleneoxide)ester of acrylic acid or methacrylic acid, such as poly(ethyleneglycol)ethyl ether acrylate, poly(ethyleneglycol)methyl ester methacrylate, and combinations thereof; and
C) As needed, monomers such as acrylic acid, methacrylic acid, styrene, hydroxystyrene, acrylate ester, methacrylate ester, acrylamide, and methacrylamide, as well as combinations of these monomers.

The quantity of the poly(alkyleneoxide) segment in the binder polymer is desirably 0.5 to 60 weight%, preferably 2 to 50 weight%, more preferably 5 to 40 weight%, and still more preferably, 5 to 20 weight%. The quantity of the (alkyleneoxide) segment in the block polymer is desirably 5 to 60 weight%, preferably 10 to 50 weight%, and more preferably, 10 to 30 weight%. The polymer binder comprising poly(alkyleneoxide) side chains can be present in the form of discrete particles.

The binder polymer desirably comprises one or more structural repeating units derived from (meth)acrylic acid, (meth)acrylate, styrene, styrene derivatives, vinyl carbazole, and poly(alkyleneglycol) (meth)acrylate. The binder polymer preferably comprises two or more structural repeating units of these monomers.

The binder polymer employed in the present invention further desirably comprises a crosslinking group. Here, the term "crosslinking group" means a group causing the binder polymer to crosslink in the course of the radical polymerization reaction taking place in the image-forming layer in the course of exposing the lithographic printing plate precursor. There is no specific limitation other than that the group perform such a function. Examples are functional groups undergoing addition polymerization reactions such as ethylenic unsaturated bond groups, amino groups, and epoxy groups. A functional group capable of becoming a radical when irradiated with light will also do. Examples of such crosslinking groups are thiol groups and halogen groups. Of these, ethylenic unsaturated bond groups are desirable. Styryl groups, (meth)acryloyl groups, and allyl groups are desirable as ethylenic unsaturated bond groups.

In the binder polymer, for example, a free radical (a radical generated in the process of polymerizing a polymerizable compound or a polymerization initiator) is added and addition polymerization is conducted directly within the polymer or through the polymerizing chain of a polymerizable compound to form and cure crosslinks between the polymer molecules. Alternatively, atoms (such as hydrogen atoms on carbon atoms adjacent to functional crosslinking groups) in the polymer are drawn off by free radicals, producing polymer radicals which then bond together forming and curing crosslinks between polymer molecules.

The content of the crosslinking groups in the binder polymer (the content of the unsaturated double bonds that can undergo radical polymerization by iodine titration) is desirably 0.01 to 10.0 mmol, preferably 0.05 to 5.0 mmol, and optimally, 0.1 to 2.0 mmol per gram of binder polymer.

In addition to the above polymerizing units containing acid groups and polymerizing units comprising crosslinking groups, the binder polymer employed in the present invention can also comprise polymerizing units in the form of alkyl or aralkyl (meth)acrylates. The alkyl group in the alkyl (meth)acrylate is desirably one having 1 to 5 carbon atoms, preferably a methyl group. An example of an aralkyl (meth)acrylate is benzyl (meth)acrylate.

The weight average molecular weight of the binder polymer is desirably 5,000 or greater, preferably 10,000 to 300,000. The number average molecular weight thereof is desirably 1,000 or greater, preferably 2,000 to 250,000. The polydispersity (weight average molecular weight/number average molecular weight) is desirably 1.1 to 10.

The binder polymer may be employed singly or in combinations of two or more. From the perspective of good strength of the image portion and image forming properties, the content of the binder polymer is desirably 5 to 75 weight%, preferably 10 to 70 weight%, and more preferably, 10 to 60 weight% relative to the total solid component of the image-forming layer.

The combined content of the polymerizable compound and binder polymer is desirably 80 weight% or less relative to the total solid component of the image-forming layer. When 80 weight% is exceeded, sensitivity decreases and the developing property sometimes deteriorates. A combined content of 35 to 75 weight% is preferred.

In the present invention, penetration of the image-forming layer by the developer is enhanced and the developing property is further improved by adjusting the proportions of the binder polymer and the polymerizable compound in the image-forming layer of the lithographic printing plate precursor. That is, the weight ratio of the radical polymerizable compound/binder polymer in the image-forming layer is desirably 1.2 or greater, preferably 1.25 to 4.5, and optimally 2 to 4.

### <Other image-forming layer components>

The image-forming layer also desirably contains a chain transfer agent. Examples of chain transfer agents that can be employed are the group of compounds comprising SH, PH, SiH, or GeH within the molecule. They donate hydrogen to radical species of low activity to produce a radical, or undergo oxidation and generate a radical by deprotonation.

In the image-forming layer, thiol compounds (such as 2-mercaptobenzimidazole, 2-mercaptobenzthiazole, 2-mercaptobenzoxazole, 3-mercaptotriazole, and 5-mercaptotetrazole) are desirably employed as chain transfer agents.

Further, various additives can be incorporated into the image-forming layer as needed. Additives such as surfactants for promoting the developing property and enhancing the coating surface, microcapsules for achieving both a good developing property and printing durability, hydrophilic polymers for improving the developing property and enhancing the dispersion stability of microcapsules, coloring agents and print-out agents for visual identification of image portions and non-image portions, polymerization inhibitors for preventing unwanted thermal polymerization of radical polymerizable compounds during manufacturing of the image-forming layer or during storage, derivatives of higher fats for preventing the blocking of polymerization by oxygen, inorganic microparticles for enhancing the strength of the cured film in image portions, hydrophilic lower molecular weight compounds for enhancing the developing property, co-sensitizing agents and chain transfer agents for enhancing sensitivity, and plasticizers for enhancing plasticity can be added. Known forms of each of these compounds can be employed. For example, the compounds described in paragraphs [0161] to [0215] in Japanese Laid-Open Patent Publication (KOKAI) No. 2007-206217 can be employed.

### <Forming the image-forming layer>

The image-forming layer is formed by dispersing or dissolving the various essential components set forth above in a solvent to prepare a coating liquid and applying the coating liquid. Examples of the solvent employed here are methyl ethyl ketone, ethylene glycol monomethyl ether, 1-methoxy-2-propanol, 2-methoxyethyl acetate, 1-methoxy-2-propyl acetate, and γ-butyl lactone. However, the solvent is not limited thereto. These solvents may be employed singly or as mixtures. The concentration of the solid component of the coating liquid is desirably 1 to 50 weight%.

The quantity (solid component) of image-forming layer applied on the support that is obtained upon drying is desirably 0.3 to 3.0 g/m². Various coating methods can be employed. Examples are bar coating, rotational coating, spray coating, curtain coating, dip coating, air knife coating, blade coating, and roll coating.

### <The protective layer>

A protective layer (oxygen-blocking layer) is desirably provided on the image-forming layer to block the diffusion of oxygen that impedes polymerization during exposure in the lithographic printing plate precursor of the present invention. For example, water-soluble polymer compounds of relatively good crystallinity are desirably employed as the material of the protective layer. Specifically, the use of polyvinyl alcohol as the main component yields the best effect in terms of basic characteristics such as the ability to block oxygen and removal during development.

So long as the polyvinyl alcohol that is employed in the protective layer contains unsubstituted vinyl alcohol units for the necessary oxygen-blocking property and water solubility, a portion thereof can be substituted with esters, ethers, and acetal. Similarly, a portion thereof may comprise other copolymer components. Polyvinyl alcohol is obtained by hydrolysis of polyvinyl acetate. Specific examples of polyvinyl alcohol are 71 to 100 mol% hydrolyzed polyvinyl acetate with a number of polymerizing repeat units falling within a range of from 300 to 2,400. Specific examples are PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613, and L-8 made by Kuraray Co., Ltd. These can be employed singly or mixed for use. In a desirable mode, the content of polyvinyl alcohol in the protective layer is 20 to 95 weight%, preferably 30 to 90 weight%.

Known modified polyvinyl alcohols are desirably employed. In particular, acid-modified polyvinyl alcohols comprising carboxylic acid groups or sulfonic acid groups are desirably employed. From the perspective of the oxygen-blocking ability and removal during development, polyvinyl pyrrolidone and its modified products are desirable as components that are mixed with polyvinyl alcohols for use; the content in the protective layer is 3.5 to 80 weight%, desirably 10 to 60 weight%, and preferably, 15 to 30 weight%.

As additional components of the protective layer, glycerol, dipropylene glycol, and the like can be added in quantities corresponding to several weight% of the (co)polymer to impart flexibility. Further, several weight% relative to the (co) polymer of anionic surfactants such as sodium alkyl sulfate and sodium alkyl sulfonate; ampholytic surfactants such as alkyl aminocarboxylates and alkyl aminodicarboxylates; and nonionic surfactants such as polyoxyethylene alkyl phenyl ethers can be added.

To enhance the ability to block oxygen and protect the surface of the image-forming layer, the inorganic layered compounds described in paragraphs [0018] to [0024] of Japanese Laid-Open Patent Publication (KOKAI) No. 2006-106700 are desirably incorporated.

More specifically, examples of mica compounds are natural mica in the form of muscovite, sodium mica, phlogopite, biotite, and lepidolite. Examples of synthetic mica are nonswelling micas such as fluorophlogopite mica KMg₃(AlSi₃O₁₀)F₂ and potassium tetrasilicate mica KMg₂.₅(Si₄O₁₀)F₂; and swelling micas such as sodium tetrasilicate mica NaMg_{2.5}(Si₄O₁₀)F₂, sodium and lithium taeniolite (Na, Li)Mg₂Li(Si₄O₁₀)F₂, and montmorillonite-based sodium and lithium hectorite (Na, Li)_{1/8}Mg_{2/5}Li_{1/8}(Si₄O₁₀)F₂. Synthetic smectite can also be employed.

Of the above mica compounds, fluorine-based swelling micas that are synthetic layered compounds are particularly useful. That is, mica, montmorillonite, saponite, hectorite, bentonite, and other swelling clay minerals have laminate structures comprised of unit crystal lattice layers that are about 10 to 15 A in thickness, with substantially greater substitution of metal atoms within the lattice than other clay minerals. As a result, the lattice layers have an inadequate positive charge. To compensate for this, organic cations such as Li⁺, Na⁺, Ca²⁺, Mg²⁺, amine salts, quaternary ammonium salts, phosphonium salts, and sulfonium salts adsorb between the layers. These layered compounds swell with water. In that state, they cleave readily with the application of shear, forming stable sols in water. This tendency is strong in bentonite and swelling synthetic micas, so they are useful in the present invention. In particular, from the perspectives of ready availability and uniform quality, the swelling synthetic micas are desirably employed.

The quantity of coating layer applied, following drying, desirably falls within a range of 0.05 to 10 g/m². When containing an inorganic layered compound, it preferably falls within a range of 0.1 to 0.5 g/m². When it does not contain an inorganic layered compound, it desirably falls within a range of 0.5 to 5 g/m².

### Support

The support used for the lithographic printing plate precursor according to the present invention is not specifically limited, provided that it is plate-like hydrophilic support with dimensional stability. Aluminum plate is particularly preferable as the support. The aluminum plate preferably undergoes surface treatment such as roughening or anodizing prior to use. The surface of aluminum plate may be roughened by various methods including mechanical roughening, electro-chemical roughening (eroding the surface by an electro-chemical process), and chemical roughening (selectively eroding the surface in a chemical process). Preferable examples of these methods of treatment are descried in paragraphs [0241] to [0245] of Japanese Laid-Open Patent Publication No. 2007-206217.

The support preferably has a center line average roughness of 0.10 to 1.2 µm. In this range, the support will exhibit good adhesiveness with the image recording layer, good printing durability, and good staining resistance.

Color density of the support is preferably 0.15 to 0.65 in terms of reflection density value. In this range, good image forming performance by virtue of suppressed halation in the process of pattern-wise exposure, and readiness of plate check after development may be ensured.

The support is preferably 0.1 to 0.6 mm thick, more preferably 0.15 to 0.4 mm thick, and still more preferably 0.2 to 0.3 mm thick.

### [Hydrophilic processing of support, undercoating layer]

In the lithographic printing plate precursor of the present invention, the support surface can be treated to render it hydrophilic or an undercoating layer can be provided between the support and the image-forming layer to increase the hydrophilic property of the non-image region and prevent print staining.

Examples of treatments to render the surface of the support hydrophilic include the method of treating the support by immersing it in an aqueous solution of sodium silicate or the like, or treating it with an alkali metal silicate or potassium fluorozirconate as an electrolytic treatment, and the method of treating it with polyvinyl phosphonate. The method of treatment by immersion in a polyvinyl phosphonate aqueous solution is desirably employed.

An undercoating layer having a compound comprising an acid group such as phosphonic acid, phosphoric acid, or sulfonic acid is desirably employed as the undercoating layer. These compounds desirably further comprise a polymerizable group to enhance adhesion to the image-forming layer. Compounds having hydrophilic property-imparting groups such as ethyleneoxide are also examples of suitable compounds.

These compounds can be low molecular weight or high molecular weight polymers. The silane coupling agent comprising an ethylenic double bond reactive group capable of undergoing addition polymerization that is described in Japanese Laid-Open Patent Publication (KOKAI) Heisei No. 10-282679 and the phosphorous compound having an ethylenic double-bond reactive group that is described in Japanese Laid-Open Patent Publication (KOKAI) Heisei No. 2-304441 are suitable examples.

Examples of optimal undercoating layers are those containing the various crosslinking compounds (desirably ethylenic unsaturated bond groups) described in Japanese Laid-Open Patent Publication (KOKAI) Nos. 2005-238816, 2005-125749, 2006-239867, and 2006-215263, and those containing low molecular weight and high molecular weight compounds having hydrophilic groups and functional groups that interact with the surface of the support.

The quantity (solid component) of the undercoating layer is desirably 0.1 to 100 mg/m², preferably 1 to 30 mg/m².

### Back Coat Layer

The lithographic printing plate precursor according to the present invention may be provided with a back coat layer on the back surface of the support as necessary. The back coat layer is preferably exemplified by a cover layer composed of the organic polymer compounds described in Japanese Laid-Open Patent Publication No. H05-45885, or composed of the metal oxides described in Japanese Laid-Open Patent Publication No. H06-35174 which are obtained by allowing organic metal compound or inorganic metal compound to hydrolyze or undergo polycondensation. Among them, alkoxy compounds of silicon, such as Si(OCH₃)₄, Si(OC₂H₅)₄, Si(OC₃H₇)₄, Si(OC₄H₉)₄ are preferable in view of inexpensiveness and availability of the source materials.

By way of example, the lithographic printing plate that is obtained by the method for manufacturing a lithographic printing plate of the present invention is mounted on the plate cylinder of a press and fountain solution and printing ink are supplied to suitably provide multiple sheets of a printed material.

### (B: The developing step)

The method for manufacturing a lithographic printing plate of the present invention comprises a step of using a pH 4 to 10 developer to develop the negative-type lithographic printing plate precursor that has been exposed (developing step). It does not comprise a water washing step or gumming step following development.

### <The developer>

Any developer that has been adjusted to pH 4 to 10 can be employed in the method for manufacturing a lithographic printing plate of the present invention. Specific examples are surfactants and hydrophilic polymer water-soluble solutions such as those described in European Patent 1342568; International Publications WO 05/111727 and WO 07/057349; aqueous solutions in which organic solvents are rendered soluble by surfactants such as those described in US Patent Application 2010/0216067 and International Publication WO 08/027227; and carbonate aqueous solutions such as those described in Japanese Laid-Open Patent Publication (KOKAI) No. 2009-086344.

The various components that can be employed in the developer of the present invention will be described below.

### (Surfactants)

The developer of the present invention can contain the following surfactants (anionic, nonionic, cationic, ampholytic, and the like).

The anionic surfactant used for the developer in the present invention is not specifically limited and is preferably selectable from fatty acid salts, abietate salts, hydroxyalkanesulfonate salts, alkanesulfonate salts, dialkylsulfosuccinate salts, straightchain alkylbenzenesulfonate salts, branched alkylbenzenesulfonate salts, alkylnaphthalenesulfonate salts, alkyl diphenyl ether (di)sulfonate salts, alkylphenoxypolyoxyethylenepropylsulfonate salts, polyoxyethylenealkylsulfophenyl ether salts, sodium salts of N-methyl-N-oleyltaurin, disodium salts of N-alkyl sulfolsuccinate monoamide, petroleum sulfonate salts, sulfated castor oil, sulfated beef tallow, sulfate ester salts of fatty acid alkyl ester, alkyl sulfate ester salts, polyoxyethylenealkyl ether sulfate ester salts, fatty acid monoglyceride sulfate ester salts, polyoxyethylenealkylphenyl ether sulfate ester salts, polyoxyethylenestyrylphenyl ether sulfate ester salts, alkylphosphoester salts, polyoxyethylenealkyl ether phosphoester salts, polyoxyethylenealkylphenyl ether phosphoester salts, partially saponified styrene-maleic anhydride copolymer, partially saponified olefin-maleic anhydride copolymer, and naphthalene sulfonate salt-formalin condensates. Among them, alkylbenzenesulfonate salts, alkylnaphthalenesulfonate salts, and alkyldiphenyl ether (di)sulfonate salts are particularly preferable.

The cationic surfactant used for the developer in the present invention is arbitrarily selectable from those known in the art, without special limitation. The examples include alkylamine salts, quaternary ammonium salts, polyoxyethylene alkylamine salts, and polyethylene polyamine derivative.

The nonionic surfactant used for the developer in the present invention is not specifically limited, and is selectable from ethylene oxide adduct of polyethylene glycol-type higher alcohol, ethylene oxide adduct of alkylphenol, ethylene oxide adduct of alkylnaphthol, ethylene oxide adduct of phenol, ethylene oxide adduct of naphthol, ethylene oxide adduct of fatty acid, ethylene oxide adduct of polyhydric alcohol fatty acid ester, ethylene oxide adduct of higher alkylamine, ethylene oxide adduct of fatty acid amide, ethylene oxide adduct of fat, ethylene oxide adduct of polypropylene glycol, dimethylsiloxane-ethylene oxide block copolymer, dimethylsiloxane-(propylene oxide - ethylene oxide) block copolymer, fatty acid ester of polyhydric alcohol-type glycerol, fatty acid ester of pentaerythritol, fatty acid ester of sorbitol and sorbitan, fatty acid ester of sucrose, polyhydric alcohol alkyl ether, and fatty acid amide of alkanolamines. Among them, those having an aromatic ring and an ethylene oxide chain are preferable, and more preferable examples include ethylene oxide adduct of alkyl substituted or unsubstituted phenol, or ethylene oxide adduct of alkyl substituted or unsubstituted naphthol.

The ampholytic ion-based surfactant used for the developer in the present invention is not specifically limited, and is selectable from amine oxide-based surfactant such as alkyldimethylamine oxide; betaine-based surfactant such as alkyl betaine; and amino acid-based surfactant such as sodium salt of alkylaminofatty acid. In particular, alkyl dimethylamine oxide which may have a substituent group, alkyl carboxybetaine which may have a substituent group, and alkyl sulfobetaine which may have a substituent group are preferably used.

As specific examples of the above, the surfactants described in paragraphs [0255] to [0278] of Japanese Laid-Open Patent Publication (KOKAI) No. 2008-203359 and in paragraphs [0028] to [0052] of Japanese Laid-Open Patent Publication (KOKAI) No. 2008-276166 can be employed.

These surfactants can be employed singly, or two or more can be combined for use.

These are available as commercial products such as the "Anhitol" series made by Kao (Ltd.), the "Softazoline" series made by Kawaken Fine Chemicals (Ltd.), the "Pionin C" series made by Takemoto Oil and Fat (Ltd.), and the "Softamin" and "Ovazolin" series made by TOHO Chemical Industry (Ltd.).

The content of surfactant in the developer is desirably 0.5 to 20 weight% or less. At 1 weight% or greater, the developing property of the non-image portion of the image-forming layer improves. At less than 20 weight%, the tackiness of the surface of the lithographic printing plate becomes acceptable. A content of 1 to 15 weight% is preferred, and a content of 3 to 10 weight% in the developer is optimal.

### (Water-soluble polymer compound)

To protect the surface of the non-image portion after removing the developed portion from the image-forming layer, the developer can contain a water-soluble polymer compound.

Examples of water-soluble polymer compounds that can be employed in the present invention are soy polysaccharides, starch, gum arabic, dextrin, cellulose derivatives, (such as carboxymethyl cellulose, carboxyethyl cellulose, and methyl cellulose), modified products thereof, pullulan, polyvinyl alcohol and derivatives thereof, polyvinyl pyrrolidone, polyacrylamide, polyacrylamide copolymers, vinyl methyl ether/maleic anhydride copolymer, vinyl acetate/maleic anhydride copolymer, and styrene/maleic anhydride copolymer.

The acid value of the water-soluble polymer compound is desirably 0 to 3.0 meq/g.

Conventionally known soy polysaccharides can be employed. An example is Soyafive (made by Fuji Oil (Ltd.)). Various grades of product can be employed. Products with a 10 weight% aqueous solution viscosity falling within a range of 10 to 100 mPa/s are desirably employed.

Examples of the above starch are sweet potato starch, potato starch, tapioca starch, wheat starch, corn starch, and modified starches and starch derivatives therefrom.

Modified starches can be produced by the method of using an acid, enzyme, or the like to decompose each molecule into 5 to 30 glucose residues, and adding oxypropylene in an alkali.

Desirable starch derivatives are torrefied starches such as British gum, enzyme dextrin, enzyme-modified dextrins such as Schardinger dextrin, oxidized starches indicated to be soluble starches, pregelatinized starches such as modified pregelatinized starches and unmodified pregelatinized starches, phosphate starch, fatty starch, sulfate starch, nitrate starch, xanthate starch, carbamate starch, and other esterified starches; carboxyalkyl starch, hydroxyalkyl starch, sulfoalkyl starch, cyanoethyl starch, allyl starch, benzyl starch, carbamylethyl starch, dialkylamino starch, and other etherified starches; methylol crosslinked starch, hydroxyalkyl crosslinked starch, phosphoric acid crosslinked starch, carboxylic acid crosslinked starch, and other crosslinked starches; starch-polyacrylamide copolymers, starch-polyacrylic acid copolymers, starch-polyvinyl acetate copolymers, starch-polyacrylonitrile copolymers, cationic starch-polyacrylic ester copolymers, cationic starch-vinyl polymer copolymers, starch-polystyrene maleic acid copolymers, starch-polyethylene oxide copolymers, starch-polypropylene copolymers, and other starch graft polymers.

Of the water-soluble polymer compounds, soy polysaccharides, starch, gum arabic, dextrin, carboxymethyl cellulose, and polyvinyl alcohol are desirable. Gum arabic and starch are preferred.

The water-soluble polymer compounds can be employed in combinations of two or more.

The content of the water-soluble polymer compound in the developer is desirably 0.1 to 20 weight%, preferably 0.5 to 10 weight percent.

### [Alkali agent]

To adjust the pH and assist with dissolving the non-image portion of the image-forming layer, an alkali agent can be supplementally contained. Examples of alkali agents are carbonates, hydrogen carbonates, and organic alkali agents. The carbonates and hydrogen carbonates are not specifically limited, but are desirably alkali metal salts. Examples of alkali metals are lithium, sodium, and potassium; sodium is preferred. Examples of organic alkali agents are monomethylamine, dimethylamine, trimethylamine, monoethylamine, diethylamine, trimethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine, and tetramethylammonium hydroxide. These alkali agents can be employed singly or two or more can be combined for use.

It is necessary for the pH of the developer to fall within a range of 4 to 10. From the perspective of the environment and operational safety, the pH desirably falls within a range of 6 to 8.

### (Organic solvent)

An organic solvent can be contained in the developer to enhance the developing property in the present invention.

The incorporation of an organic solvent further enhances the developing property. When the organic solvent in the developer that has adhered to the non-image portion following development volatilizes, the component that has been rendered soluble by the organic solvent and removed by development causes print staining. Accordingly, when there is no problem with the developing property, it is desirable to keep the content of organic solvent down both in terms of quality and the environment. The content is desirably 3 weight% or less, preferably 1 weight% or less, and ideally, essentially none is incorporated.

The solubility in 20°C water of an organic solvent that can be employed in the present invention is desirably 1.5 to 7.0 g/100 mL, preferably 2.5 to 5.0 g/100 mL.

Specific examples of organic solvents that can be employed in the present invention are 1-pentanol (2.7 g/100mL), 2-pentanol (4.5 g/100 mL), 3-pentanol (5.2 g/100 mL), 2-methyl-1-butanol (3.0 g/100 mL), 3-methyl-1-butanol (2.7 g/100 mL), 3-methyl-2-butanol (5.6 g/100 mL), neopentyl alcohol (3.5 g/100 mL), 4-methyl-2-pentanol (2.0 g/100 mL), benzyl alcohol (4.0 g/100 mL), ethylene glycol monophenyl ether (2.7 g/100 mL), propylene glycol mono-n-butyl ether (4.4 g/100 mL), propyl acetate (1.6 g/100 mL), isopropyl acetate (4.3 g/100 mL), diethylene glycol monobutyl ether acetate (6.5 g/100 mL), diethyl ketone (1.7 g/100 mL), 2-pentanone (4.0 g/100 mL), and methyl isobutyl ketone (1.9 g/100 mL). These can be employed singly, or two or more can be combined for use.

### (Wetting agent)

Wetting agents in the form of ethylene glycol, propylene glycol, triethylene glycol, butylene glycol, hexylene glycol, diethylene glycol, dipropylene glycol, glycerol, trimethylol propane, diglycerol, and the like can be suitably employed.

A single wetting agent can be employed, or two or more can be combined for use.

The wetting agent is desirably employed in a quantity of 0.1 to 5 weight% of the total weight of the developer.

### (Preservative)

Preservatives in the form of phenols and their derivatives, formalin, imidazole derivatives, dehydrosodium acetate, 4-isothiazoline-3-one derivatives, benzoisothiazoline-3-one, 2-methyl-4-isothiazoline-3-one, benzotriazole derivates, amidine guanidine derivatives, derivatives of quaternary ammonium salts, pyridine, quinoline, and guanidine, diazine, triazole derivatives, oxazole, oxazine derivatives, nitrobromo alcohol-based 2-bromo-2-nitropropane-1,3-diol, 1,1-dibromo-1-nitro-2-ethanol, 1,1-dibromo-1-nitro-2-propanol, and the like are desirably employed. Two or more preservatives are desirably combined for use so as to be effective against various molds and bacteria.

The content of the preservative is one that achieves a stable effect against bacteria, mold, yeast, and the like, and will vary depending on the type of bacteria, mold, or yeast. It desirably falls within a range of 0.01 to 4 weight% of the developer.

### (Chelate compound)

Examples of chelate compounds are ethylenediaminetetraacetic acid, potassium salts thereof, sodium salts thereof; diethylenetriaminepentaacetic acid, potassium salts thereof, and sodium salts thereof; triethylenetetraaminehexaacetic acid, potassium salts thereof, and sodium salts thereof; hydroxyethylethylenediaminetriacetic acid, potassium salts thereof, and sodium salts thereof; nitrilotriacetic acid, sodium salts thereof; 1-hydroxyethane-1,1-diphosphonic acid, potassium salts thereof, sodium salts thereof; aminotri(methylenephosphonic acid), potassium salts thereof, sodium salts thereof; and other organic phosphonic acids and phosphonoalkanetricarboxylic acids. Instead of sodium salts and potassium salts of the above chelates, organic amine salts are also effective.

Chelate agents are desirably selected to remain stably in the developer and not impede printing properties.

The content of the chelate agent is desirably 0.001 to 1.0 weight% relative to the total weight of the developer.

### (Antifoaming agent)

Generally, compounds of the silicone-based self-emulsifying type and emulsifying type with a nonionic hydrophile-lipophile balance (HLB) of 5 or lower can be employed as antifoaming agents. Silicone antifoaming agents are desirable. Of these, both the emulsifying dispersion type and soluble type can be employed.

The content of the antifoaming agent desirably falls within a range of 0.001 to 1.0 weight% relative to the total weight of the developer.

### (Organic acid)

Examples or organic acids are citric acid, acetic acid, oxalic acid, malonic acid, salicylic acid, caprylic acid, tartaric acid, malic acid, lactic acid, levulinic acid, p-toluenesulfonic acid, xylenesulfonic acid, phytic acid, and organic phosphonic acid. The organic acid can be employed in the form of an alkali metal salt or ammonium salt.

The content of the organic acid is desirably 0.01 to 0.5 weight% relative to the total weight of the developer.

### (Inorganic acid, inorganic salt)

Examples of inorganic acids and inorganic salts are phosphoric acid, metaphosphoric acid, monobasic ammonium phosphate, dibasic ammonium phosphate, monobasic sodium phosphate, dibasic sodium phosphate, monobasic potassium phosphate, dibasic potassium phosphate, sodium tripolyphosphate, potassium pyrophosphate, sodium hexametaphosphate, magnesium nitrate, sodium nitrate, potassium nitrate, ammonium nitrate, sodium sulfate, potassium sulfate, ammonium sulfate, sodium sulfite, ammonium sulfite, sodium hydrogensulfate, and nickel sulfate.

The content of inorganic acids and inorganic salts is desirably 0.01 to 0.5 weight% relative to the total weight of the developer.

### (Water)

The developer of the present invention is prepared for use by dissolving or solubilizing the above components in water.

Here, the term "water" refers to pure water, distilled water, ion-exchange water, tap water, or the like. Water of any hardness can be employed.

The content of water in the developer is desirably 50 weight% or higher.

The developing treatment in the above developing step is not specifically limited. Developing can be conducted by any known method. However, development is desirably implemented with an automatic processor equipped with a rubbing member. The development treatment can also be suitably implemented with an automatic processor equipped with a means of feeding the above developer or the like. An example of an automatic processor is that described in Japanese Laid-Open Patent Publication (KOKAI) No. 2006-235227 in which rubbing is conducted while conveying a lithographic printing plate precursor following image recording. Among such devices, automatic processors employing rotating brush rolls as rubbing members are preferred.

Rotating brush rolls that are desirably employed in the present invention can be suitably selected taking into account the tendency of the image portion to scratch, the strength of the mid-section of the lithographic printing plate precursor support, and the like.

Known rotating brush rolls that are formed by embedding brush bristles in a plastic or metal roll can be employed. For example, brush rolls wound radially with embedded rows of brush bristles, without gaps between plastic or metal rolls with grooved cores of metal or plastic, such as those described in Japanese Laid-Open Patent Publication (KOKAI) Showa No. 58-159533, Heisei No. 3-100554, and Japanese Utility Model Publication (JIKKO) Showa No. 62-167253, can be employed.

Bristles of a plastic fiber (such as a synthetic fiber of a polyester such as polyethylene terephthalate or polybutylene terephthalate, a polyamide such as Nylon 6.6 or Nylon 6.10, a polyacrylic such as polyacrylonitrile or alkyl poly(meth)acrylate, or a polyolefin such as polypropylene or polystyrene) can be employed. For example, fiber bristles that are 20 to 400 µm in diameter and 5 to 30 mm in length can be suitably employed.

The outer diameter of the rotating brush rolls is desirably 30 to 200 mm, and the rim speed of the tip of the brush rubbing the plate surface is desirably 0.1 to 5 m/s.

The rotational direction of the rotating brush rolls can be identical to or opposite that of the direction of conveyance of the lithographic printing plate precursor. When employing two or more rotating brush rolls, it is desirable for at least one of the rotating brush rolls to rotate in the same direction and at least one of the rotating brush rolls to rotate in the opposite direction. Thus, removal of the unexposed portion of the image-forming layer is rendered more reliable. It is also effective to cause the rotating brush rolls to rock in the direction in which they rotate.

The developer employed in the present invention can be constantly employed in the form of fresh solution. However, it is desirable to recycle the developer following the developing process through a filter for repeated use.

Any filter that is capable of filtering out foreign matter contaminating the developer can be employed to filter the developer in the developing step. Polyester resin, polypropylene resin, polyethylene resin, cellulose resin, cotton, or the like is desirably employed as the filter material. The material is desirably contained in the form of a cartridge within a housing in a replaceable filter. The cartridge is desirably of a pleated type in which pleats have been formed to increase the filter surface area and filter paper made of cellulose fiber is processed with an epoxy resin for reinforcement and to prevent fiber separation; a depth type in which yarn (a fiber bundle) comprised of numerous fibers is wound to achieve a gentle density gradient around a center tube; or an adsorbing type in which an adsorbing agent is contained in a plastic case of polyethylene or the like or an adsorbing agent of activated carbon or the like is supported in a medium comprised primarily of resin, cellulose, glass fiber, or water-absorbing polymer. A material selected from among silica gel, activated carbon, activated aluminum, a molecular sieve, clay, ultra-absorbent fiber, calcium carbonate, calcium sulfate, potassium permanganate, sodium carbonate, potassium carbonate, sodium phosphate, and activated metals, and the ion-exchange materials employed in various filters, can be employed as the adsorbing agent.

Available filters in the form of "TCW type," "TCP type," "TCS type" and similar cartridge filters made by Advantec Toyo (Ltd.) are desirably employed.

The mesh size of the filter is desirably 5 to 500 µm, preferably 10 to 200 µm, and more preferably, 20 to 100 µm.

The method for manufacturing lithographic printing plates of the present invention does not comprise a water-washing step or gumming step between the developing step and the burning step, described further below.

Here, the terms "water-washing step" and "gumming step" refer to those that are normally conducted following the developing step in a three-bath developing system. The water-washing step is conducted to prevent printing staining due to the re-adhesion on the plate surface of components removed during developing, and to inhibit printing staining caused by components that have re-adhered to the plate surface from fixing to the non-image portion during burning. The use of common tap water, well water, ion-exchange water, and distilled water is known. A continuous supply of fresh water can be employed in the water-washing step. Recycling the water employed in the water-washing step through a filter such as one of those set forth above for reuse is also known.

Generally, following the water-washing step, feeding a gum solution onto the plate surface to adequately desensitize the non-image portion is known as the gumming step (step of desensitizing the non-image portion with a gum solution). The desensitizing agent employed in the gum solution is generally gum arabic. Additionally, various water-soluble resins can be given as examples: dextrin, sterabic, stractan, alginates, polyacrylates, hydroxyethyl cellulose, polyvinyl pyrrolidone, polyacrylamide, methyl cellulose, hydroxypropyl cellulose, hydroxymethyl cellulose, salts of carboxyalkyl cellulose, water-soluble polysaccharides extracted from soy curds, pullulan, pullulan derivatives, and polyvinyl alcohol.

Occasionally, the gumming step desensitizes the image portion of the surface, resulting in a problem in the form of deterioration of the ink buildup property.

In the present invention, even in single-bath processing in which neither a water-washing step nor a gumming step is conducted, it was discovered that conducting a treatment with a burning surface-treatment liquid within one minute or more to 10 hours of development (desirably within 2 minutes or more but not more than 5 hours and preferably within 3 minutes or more but not more than 3 hours) caused components that had been removed by development not to re-adhere to the plate surface and prevented fixation of hydrophobic organic material during burning. Thus, even when conducting a burning treatment on a plate in which heightened resistance to printing was desired, a considerable effect was achieved in reducing the quantity of water and chemicals employed and treatment with a single solution was possible, obviating the need for a water-washing step or a gumming step.

The temperature during the period of from 1 minute to 10 hours following development is desirably 5 to 35°C, preferably 15 to 25°C.

In the present invention, a drying step can optionally be provided following the developing step. It is preferably provided as the final step in an automatic processor.

The drying step desirably consists of removing most of the developer with roller nips and then blowing with dry air at a desired temperature.

### (C: The step of treatment with a burning surface-treatment liquid)

The method for manufacturing a lithographic printing plate of the present invention comprises the step of treating the developed negative-type lithographic printing plate precursor with a burning surface-treatment liquid.

Conventionally known burning surface-treatment liquids can be employed in the present invention without limitation. Specific examples are those described in Japanese Laid-Open Patent Publication (KOKAI) Showa No. 62-242946 and No. 2005-10675.

The various components of the burning surface-treatment liquid employed in the present invention will be described below. Examples of such additives are surfactants, various salts, acids, and alkalis in addition to those set forth above.

### (Surfactants)

Surfactants help achieve a uniform coating of the burning surface-treatment liquid employed in the present invention on the surface of the lithographic printing plate. Some also play roles in inhibiting the generation of grime on the non-image portion during the burning treatment. Desirable surfactants are anionic surfactants. Of these, alkylbenzene sulfonates, alkyldiphenyl ether disulfonates, alkylnaphthalene sulfonates, aldehyde condensates of alkylnaphthalene sulfonates, α-olefin sulfonates, and other sulfonic acid group-containing surfactants; lauryl sulfuric acid esters, polyoxyethylene alkyl ether sulfates, polyoxyethylene alkyl phenyl ether sulfonates, and other sulfuric acid ester surfactants are preferred. The surfactant is suitably incorporated into the burning surface-treatment liquid in a range of 0.05 to 10 weight%, desirably in a range of 0.1 to 5 weight percent.

### (Acids, alkalis, and salts)

Acids, alkalis, and salts can be employed as needed to adjust the pH in the burning surface-treatment liquid of the present invention. Both organic and inorganic acids can be employed. Examples are inorganic acids such as nitric acid, sulfuric acid, and phosphoric acid; organic acids such as citric acid, succinic acid, oxalic acid, tartaric acid, acetic acid, and malic acid; their potassium salts, lithium salts, sodium salts, and ammonium salts; and alkali metal hydroxides, carbonates, and hydrogen carbonates.

These acids, salts, and alkalis can be incorporated in quantities that adjust the pH of the burning surface solution to pH 2 to 10, desirably to within a range of pH 3 to 8.

### (Other)

Small quantities of gum arabic, dextrin, carboxymethyl cellulose, polyacrylic acid, polymethacrylic acid, and salts thereof (such as sodium salts), such as water-soluble polymer substances, dyes, antifoaming agents, wetting agents, and preservatives can be added to the burning surface-treatment liquid.

The burning surface-treatment liquid of the present invention is suitably employed at a solution temperature of 15 to 35°C. The burning surface-treatment liquid of the present invention is applied by the method of coating on the lithographic printing plate with a sponge or degreased cotton that has been immersed in the pretreatment liquid, by the method of coating by immersing the printing plate in a pad filled with the treatment liquid, by forming a coating with an automatic coater, or the like. After the coating has been formed, a preferred effect is achieved by using a squeegee or a squeegee roller to render the coating uniform.

When necessary, the lithographic printing plate on which the burning surface-treatment liquid has been coated is dried and then heated to an elevated temperature with a burning processor (such as the Burning Processor 1300 sold by Fuji Film (Ltd.)) or the like. In that case, the heating temperature and time will depend on the components being used to form the image, but desirably falls within a range of 180 to 300°C for 1 to 20 minutes.

### (D: The burning treatment step)

The method of manufacturing lithographic printing plates of the present invention comprises a step of subjecting a negative-type lithographic printing plate precursor to a burning treatment following treatment with the burning surface-treatment liquid.

The lithographic printing plate that has been subjected to the burning treatment can advance as is to the printing step. As needed, it can be subjected to suitable conventionally conducted processing such as water washing and gumming with a desensitizing gum solution. However, following the burning treatment, so-called desensitizing treatments such as gumming can be omitted.

The lithographic printing plate obtained by this processing can be mounted in an offset printer and used to print multiple sheets.

### EXAMPLES

Features of the present invention will further be detailed referring to Examples. Note that the amount of use, ratio, details of processes, and procedures of processes described in Examples below may be arbitrarily modified, without departing from the spirit of the present invention. The scope of the present invention is, therefore, not restrictively understood by the specific examples described below.

### <Description of terms relating to chemical substances used in polymer particle synthesis and image-forming layer coating liquid>

- PEGMA: 50 weight% aqueous solution of poly(ethyleneglycol)methyl ether methacrylate with number average molecular weight (Mn) of 2,080 available from Sigma-Aldrich (St. Louis, Missouri)
- Hybridur 580: Urethane-acrylic hybrid polymer dispersion (40%) available from Air Products and Chemicals
- Hybridur 870: Urethane-acrylic hybrid polymer dispersion (40%) available from Air Products and Chemicals
- SR399: Dipentaerythritol pentaacrylate available from Sartomer Japan
- NK-Ester A-DPH: Dipentaerythritol hexaacrylate available from Shin Nakamura Chemical (Ltd.)
- CD9053: Trifunctional organic acid ester compound available from Sartomer Japan
- Fluor N2900: Surfactant available from Cytnix
- Masurf FS-1520: Alkyl fluoride group-containing ampholytic surfactant available from Mason Chemical

### <Binder polymer 1>

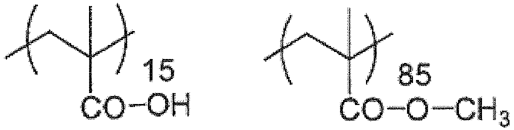

Binder polymer 1
(acid value = 85 mgKOH/g)

### <Binder polymer 2>

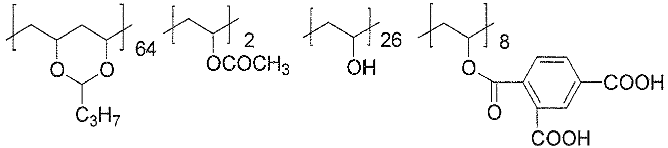

Binder polymer (2) (acid value = 66 mgKOH/g)

### <Synthesis of binder polymer 3>

To a three-necked flask equipped with magnetic stirrer, water bath, and N₂ inlet were charged AIBN (2,2'-azobis(isobutyronitrile), Vazo-64, made by DuPont, 1.6 parts), methyl methacrylate (20 parts), acrylonitrile (24 parts), N-vinyl carbazole (20 parts, made by Polymer Dajac), methacrylic acid (16 parts), and dimethylacetamide (DMAC, 320 parts). The reaction mixture was heated to 60°C and then stirred overnight (16 hours) under N₂ protection. This yielded a DMAC 20% solution of binder polymer 3.

The composition of binder polymer 3 was methyl methacrylate/acrylonitrile/N-vinyl carbazole/methacrylic acid = 21/48/11/20 (molar ratio). Measurement of the molecular weight by gel permeation chromatography in tetrahydrofuran revealed the Mw (weight average molecular weight) to be about 52,000.

### <Synthesis of binder polymer 4>

Two hundred parts of the DMAC solution of binder polymer 3 thus synthesized were weighed out. To this was gradually added potassium hydroxide (2.6 parts) in water (20 parts), forming a viscous liquid. The mixture was stirred for 10 minutes, after which allyl bromide (6.7 parts) was added. The mixture was then stirred at 55°C for 3 hours. To the flask was added 36% concentrated hydrochloric acid (6 parts) in DMAC (20 parts), after which the reaction mixture was stirred for another 3 hours. The resulting reaction mixture was slowly added dropwise with stirring to a mixture of 12,000 parts of icewater and 20 parts of concentrated hydrochloric acid. The resulting precipitate was filtered out and washed with 1,608 parts of propanol, and then washed with 2,000 parts of water. Following filtration, a white powder was obtained. The white powder was dried overnight at room temperature (10 to 25°C) and then for 3 hours at 50°C, yielding about 40 parts of binder polymer 4 in the form of a solid.

The composition of binder polymer 4 was methyl methacrylate/acrylonitrile/N-vinyl carbazole/allyl methacrylate = 21/48/11/20 (molar ratio). The Mw, measured as set forth above, was about 57,000.

### <Synthesis of binder polymer 5>

With the exceptions that no acrylonitrile was employed, the quantity of methyl methacrylate was made 65 parts, and the quantity of DMAC was made 400 parts, a DMAC 20% solution of binder polymer 5 was obtained in the same manner as in the synthesis of binder polymer 3 above.

The composition of binder polymer 5 was methyl methacrylate/N-vinyl carbazole/methacrylic acid = 69/11/20 (molar ratio). The Mw, measured as set forth above, was about 55,000.

### <Synthesis of binder polymer 6>

With the exceptions that no N-vinyl carbazole was employed, the quantity of methyl methacrylate was made 30 parts, and the quantity of DMAC was made 280 parts, a DMAC 20% solution of binder polymer 6 was obtained in the same manner as in the synthesis of binder polymer 3 above.

The composition of binder polymer 6 was methyl methacrylate/acrylonitrile/methacrylic acid = 32/48/20 (molar ratio). The Mw, measured as set forth above, was about 50,000.

### <Synthesis of binder polymer 7>

To a four-necked glass flask equipped with heating mantle, temperature regulator, mechanical stirrer, reflux condenser, dropping funnel, and nitrogen feed inlet were added DMAC (100.7 parts) and PEGMA (50% aqueous solution, 20 parts). Under a nitrogen flow, the reaction mixture was heated to 80°C. Premixed DMAC (125 parts), vinyl carbazole (25 parts), acrylonitrile (35 parts), styrene (20 parts), methacrylic acid (10 parts), and AIBN (0.5 part, Vazo-64) were added at 80°C over 2 hours. Subsequently, the reaction was then conducted while adding 1.25 parts of Vazo-64 and then for 15 hours. Quantitative measurement of the volatile components revealed the monomer reaction rate to be 99% or higher. The polymer solution obtained was reprecipitated from 6,000 parts of water/ice (3:1) that were being rapidly stirred. The polymer powder that precipitated was filtered out, dried for 24 hours at room temperature, and then dried for 2 days at 43°C, yielding binder polymer 7 in the form of a powder. The yield was 95% and the acid value was 69 mgKOH/g (theoretical value: 65).

The composition of binder polymer 7 was PEGMA/acrylonitrile/vinyl carbazole/styrene/ ethacrylic acid = 0.5/60/12/17/11 (molar ratio). The Mw, measured as set forth above, was about 100,000.

### <Synthesis of urethane-acrylic hybrid polymer 1>

Formrez 55-56 (poly(neopentyladipate), a polyol available from Witco Chemical, Mw about 2,000) (100 parts) was charged to a reactor that had been purged with nitrogen. To this were added methylene dicyclohexyl diisocyanate (90.6 parts) and 10% DABCO T-12, a tin catalyst (dibutyltin dilaurate available from Air Products and Chemicals) (0.25 part). The mixture was stirred for 3 hours at 92°C. While stirring at a constant rate, dimethylolpropionic acid (14.8 parts) was added. Next, 1-methyl-2-pyrrolidinone (54.6 parts) was added. The mixture was maintained for another 5 hours at 92°C.

The prepolymer was cooled to 75°C and butyl methacrylate (141.6 parts) and 1,6-hexanediole diacrylate (0.88 part) were added. The mixture was stirred for 15 minutes, at which point the free NCO% was measured. The NCO level was nearly 0%. Next, the mixture was cooled to 25°C, triethylamine (10.66 parts) was added, and the mixture was reacted for one hour. Following neutralization, the prepolymer/monomer mixture was dispersed in deionized water (498.97 parts). For chain lengthening, ethylenediamine (8.97 parts) was dissolved in deionized water (16.67 parts), added to the reactor, and reacted for 2 hours. Next, free radical initiator Vazo-64 (AIBN available from DuPont) (0.88 part) dissolved in 1-methyl-2-pyrrolidinone (6.93 parts) was added, and a mixture of butyl methacrylate (31.4 4 parts) and 2-hydroxyethylmethacrylate (29.12 parts) was added. Five minutes later, the dispersion was heated to 75°C, where it was maintained for 2 hours.

When polymerization had ended, the dispersion was passed through a filter, yielding urethane-acrylic hybrid polymer 1.

The Mw of urethane-acrylic hybrid polymer 1 obtained was about 150,000. Measurement using a laser diffraction/scattering particle size distribution analyzer LA-910 made by Horiba (Ltd.) revealed a particle size ma (mean diameter of area distribution) of 360 nm.

### <Synthesis of urethane-acrylic hybrid polymer 2>

Formrez 55-56 (poly(neopentyladipate), a polyol available from Witco Chemical, Mw about 2,000) (200.1 parts) was charged to a reactor that had been purged with nitrogen. To this were added methylene dicyclohexyl diisocyanate (105.3 parts) and 10% DABCO T-12, a tin catalyst (dibutyltin dilaurate available from Air Products and Chemicals) (0.52 part). The mixture was stirred for 3 hours at 92°C. While stirring at a constant rate, dimethylolpropionic acid (26.8 parts) was added. Next, 1-methyl-2-pyrrolidinone (110 parts) was added. The mixture was maintained for another 5 hours at 92°C.

The prepolymer was cooled to 75°C and methyl methacrylate (199.7 parts) was added. The mixture was stirred for 15 minutes, at which point the free NCO% was measured. The NCO level was about 1 to 1.5%. Next, the mixture was cooled to 25°C, triethylamine (19.5 parts) was added, and the mixture was reacted for one hour. Following neutralization, methyl methacrylate (64.2 parts) and 2-hydroxyethyl methacrylate (64.2 parts) were added and the mixture was stirred for 5 minutes. Next, the prepolymer was dispersed in deionized water (800.2 parts). To stop the chain, diethanolamine (18.6 parts) was dissolved in deionized water (32.5 parts), added to the reactor, and reacted for 2 hours. Next, free radical initiator Vazo-67 (2,2'-azobis(2-methylbutyronitrile) available from DuPont) (3.94 parts) dissolved in 1-methyl-2-pyrrolidinone (13.52 parts) and thiol chain transfer agent 1-dodecylthiol (20.2 part) were added. Five minutes later, the dispersion was heated to 75°C, where it was maintained for 2 hours, yielding urethane-acrylic hybrid polymer 2.

The Mw of urethane-acrylic hybrid polymer 2 that was obtained was about 30,000 and the particle size as measured by the method set forth above was ma=230 nm.

### <Synthesis of urethane-acrylic hybrid polymer 3>

With the exception that the diisocyanate compound employed was changed from methylenedicyclohexyl diisocyanate to diphenylmethane diisocyanate (MDI), urethane-acrylic hybrid polymer 3 was synthesized in the same manner as in the synthesis of urethane-acrylic hybrid polymer 1 above.

The Mw of urethane-acrylic hybrid polymer 3 obtained was about 100,000. The particle size as measured by the above method was ma = 300 nm.

### <Synthesis of urethane-acrylic hybrid polymer 4>

With the exception that the diisocyanate compound employed was changed from methylenedicyclohexyl diisocyanate to m-tolylene diisocyanate (TDI), urethane-acrylic hybrid polymer 4 was synthesized in the same manner as in the synthesis of urethane-acrylic hybrid polymer 1 above.

The Mw of urethane-acrylic hybrid polymer 4 obtained was about 130,000. The particle size as measured by the above method was ma = 320 nm.

### <Synthesis of urethane-acrylic hybrid polymer 5>

With the exception that the diisocyanate compound employed was changed from methylenedicyclohexyl diisocyanate to isophorone diisocyanate (IpDI), urethane-acrylic hybrid polymer 5 was synthesized in the same manner as in the synthesis of urethane-acrylic hybrid polymer 1 above.

The Mw of urethane-acrylic hybrid polymer 5 obtained was about 150,000. The particle size as measured by the above method was ma = 340 nm.

### <Synthesis of urethane-acrylic hybrid polymer 6>

With the exception that the diisocyanate compound employed was changed from methylenedicyclohexyl diisocyanate to hexamethylene diisocyanate (HMDI), urethane-acrylic hybrid polymer 6 was synthesized in the same manner as in the synthesis of urethane-acrylic hybrid polymer 1 above.

The Mw of urethane-acrylic hybrid polymer 6 obtained was about 180,000. The particle size as measured by the above method was ma = 420 nm.

### (Examples 1 to 27 and Comparative Examples 1 to 15)

### (Preparation of lithographic printing plate precursor (1))

### <Fabrication of support 1 >

An aluminum sheet (material 1050, thermal refining H16) 0.24 mm in thickness was immersed in a 5% sodium hydroxide aqueous solution maintained at 65°C, subjected to a degreasing treatment for 1 minute, and washed with water. The degreased aluminum sheet was then immersed for one minute in a 10% hydrochloric acid aqueous solution to neutralize it, and then washed with water. Next, the surface of the aluminum sheet was electrolytically roughened for 60 seconds with an AC current under conditions of 25°C and a current density of 100 A/dm² in a 0.3 weight% hydrochloric acid aqueous solution, and then subjected to a desmutting treatment for 10 seconds in a 5% sodium hydroxide aqueous solution maintained at 60°C. The desmutted, surface-roughened aluminum sheet was subjected to anodic oxidation under conditions of a current density of 10 A/dm² and a voltage of 15 V at 25°C in a 15% sulfuric acid aqueous solution, and then rendered hydrophilic by treatment at 75°C with a 1% polyvinyl phosphonic acid aqueous solution to prepare a support. Measurement indicated the surface roughness to be 0.44 µm (Ra denoted based on JIS B0601).

### <Formation of image-forming layer 1>

Image-forming layer coating liquid (1) of the composition given below was bar coated on the above support and oven dried for 60 seconds at 90°C to form an image-forming layer with a dry coating density of 1.3 g/m³.

### <Image-forming layer coating liquid (1)>

| | |
|---|---|
| - Binder polymer recorded in Table 1 (as solid component) | 0.50 part |
| - Polymerizing compound (1) below (PLEX6661-O, made by Degusa Japan) | 0.17 part |
| - Polymerizing compound (2) below | 0.51 part |
| - Sensitizing dye (1) below | 0.06 part |
| - Polymerization initiator (1) below | 0.13 part |
| - Chain transfer agent: mercaptobenzothiazole | 0.01 part |
| - Dispersion of ε-phthalocyanine pigment | 0.40 part |

(Pigment: 15 weight parts, dispersing agent (allyl methacrylate/methacrylic acid copolymer (weight average molecular weight: 60,000, copolymer molar ratio: 83/17)): 10 weight parts, cyclohexanone: 15 weight parts)

| | |
|---|---|
| - Thermopolymerization inhibitor | 0.01 part |

N-nitrosophenylhydroxylamine ammonium salt

| | |
|---|---|
| - Water-soluble fluorosurfactant (1) | 0.001 part |
| - 1-Methoxy-2-propanol | 3.5 parts |
| - Methyl ethyl ketone | 8.0 parts |

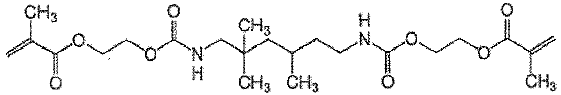

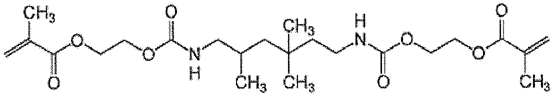

Polymerizable compound (1) (mixture of above isomers) 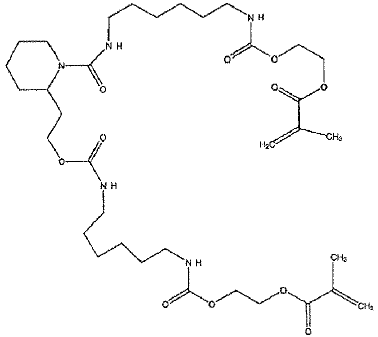 Polymerizable compound (2) 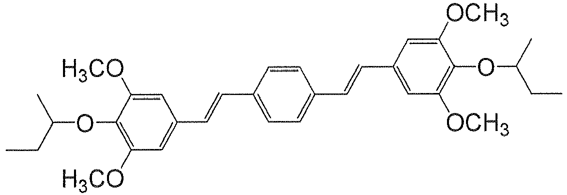 Sensitizing dye (1) 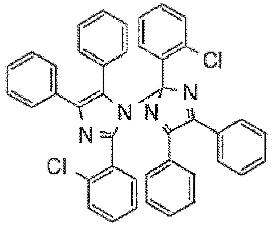 Polymerization initiator (1)

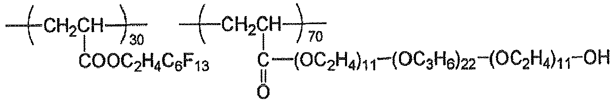

### Fluorosurfactant (1)

### <Formation of protective layer 1 >

Protective layer coating liquid (1) of the composition indicated below was coated to a dry coating density of 1.2 g/m² with a bar on the above-described image-forming surface and dried for 70 seconds at 125°C to form a protective layer. This yielded lithographic printing plate precursor (1).

### Protective layer coating liquid (1)

- PVA-205 0.658 part
(Partially hydrolyzed polyvinyl alcohol, made by Kuraray (Ltd.), degree of saponification = 86.5 to 89.5 mol%, viscosity = 4.6 to 5.4 Pa·s (20°C, in 4 weight% aqueous solution))
- PVA-105 0.142 part
(Fully hydrolyzed polyvinyl alcohol, made by Kuraray (Ltd.), degree of saponification = 98.0 to 99.0 mol%, viscosity = 5.2 to 6.0 Pa·s (20°C, in 4 weight% aqueous solution))
- Poly(vinylpyrrolidone/vinyl acetate (1/1)) (molecular weight 70,000) 0.001 part
- Surfactant (Emarex 10, made by Nihon-Emulsion (Ltd.)) 0.002 part
- Water 13 parts

### (1) Exposure and development

The lithographic printing plate precursor was exposed to an image with a Vx9600 violet semiconductor laser plate setter (with InGaN semiconductor laser 405 nm ± 10 nm emission/30 mW output) made by FUJIFILM Electronic Imaging Ltd.. The image lithography was conducted at a plate surface exposure level of 0.05 mJ/cm² with 50% halftone dots using an FM screen (TAFFETA 20) made by FUJIFILM at a resolution of 2438 dpi.

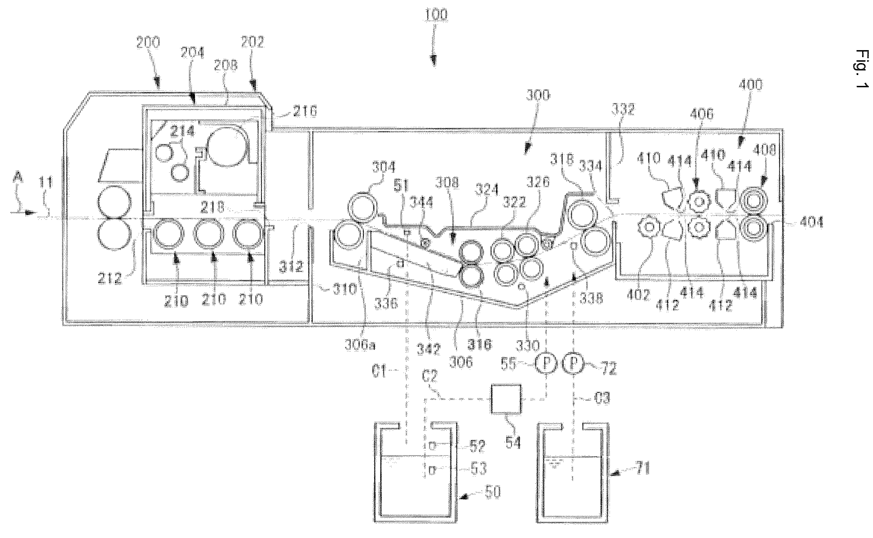

Next, using the developer recorded in Table 1, developing was implemented (Example 1) at a conveyance speed yielding an immersion period (development period) in the developer of 20 seconds with 10 seconds of preheating at 100°C using an automatic developing processor of the configuration shown in Figure 1.

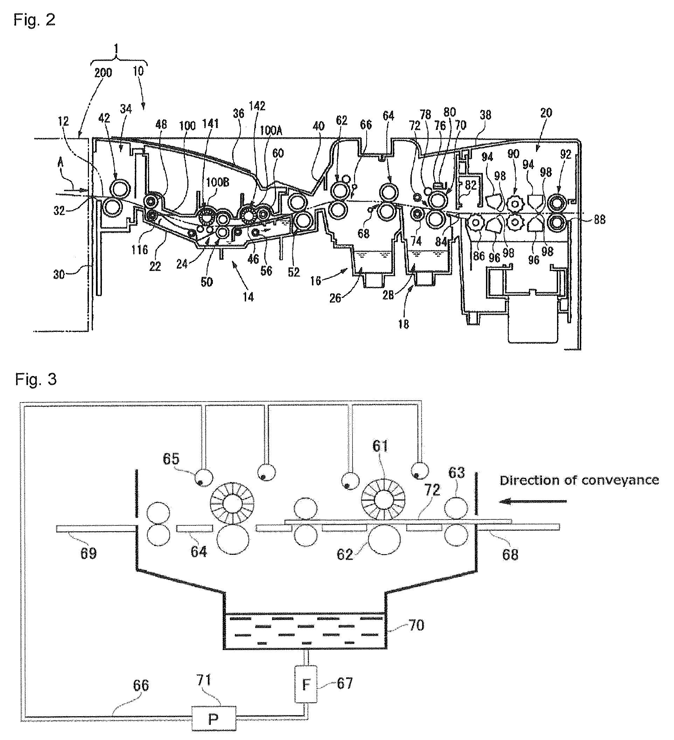

In the cases where water washing and gumming steps were conducted in the comparative examples, after conducting everything through preheating under the same conditions as above with the automatic developing processor of the configuration shown in Fig. 1, developing was conducted in the same manner as in Example 1. with the exceptions that the lithographic printing plate was removed en route and water washing was conducting with tap water in the second bath and gumming was conducted with finishing gum solution FN-6 made by FUJIFILM in the third bath using the automatic developing processor of the three-bath configuration shown in Fig. 2.

Following developing, the lithographic printing plate was subjected to a surface-treatment liquid treatment at the time intervals indicated in Table 1. The surface-treatment liquid treatment was conducted with a dip coater equipped with nip rolls using the burning surface-treatment liquid indicated in Table 1.

Following surface-treatment liquid treatment, the lithographic printing plate was processed with an oven throughput time of 3 minutes with prebaking to 150°C and postbaking to a temperature of 240°C with a burning processor made by Tsurumi Corp.

### <Developer 1>

| | |
|---|---|
| Water | 88.6 parts |
| Nonionic surfactant (W-1) | 2.4 parts |
| Nonionic surfactant (W-2) | 2.4 parts |
| Nonionic surfactant (Emarex 710, made by Nihon-Emulsion (Ltd.)) | 1.0 part |
| Phenoxypropanol | 1.0 part |
| Octanol | 0.6 part |
| N-(2-hydroxyethyl)morpholine | 1.0 part |
| Triethanolamine | 0.5 part |
| Sodium gluconate | 1.0 part |
| Trisodium citrate | 0.5 part |
| Tetrasodium ethylenediaminetetraacetate | 0.05 part |
| Polystyrene sulfonate (Versa TL77 (30% solution), made by Alco Chemical) | 1.0 part |

| | |
|---|---|
| * Phosphoric acid was added to the above developer composition to adjust it to pH 7.0. | |

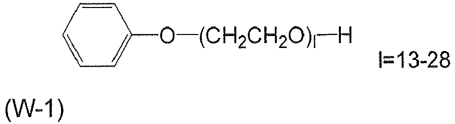

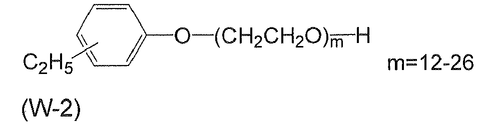

<Developer 2>
- Water Quantity to make 10,000 parts in combination with other components
- Sodium carbonate 130 parts
- Sodium hydrogencarbonate 70 parts
- Amphoteric surfactant (W-3) 500 parts
- Gum arabic 250 parts
- Hydroxyalkylated starch (Penon JE66, made by Nippon Starch Chemical (Ltd.)) 700 parts
- Monobasic ammonium phosphate 20 parts
- 2-Bromo-2-nitropropane-1,3-diol 0.1 part
- 2-Methyl-4-isothazoline-3-one 0.1 part
   *pH: 9.8

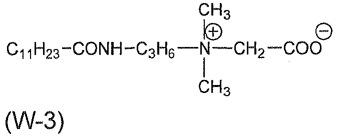

### <Developer 3>

- SP-200: Neutral developer made by Kodak containing 5 to 10% benzyl alcohol. *pH: 7.0

### <Developer 4>

- DV-3: Silicate-containing alkali developer made by FUJIFILM *pH: 12.3

### <Burning surface-treatment liquid 1>

- BC-7: Burning surface-treatment liquid made by FUJIFILM

### <Burning surface-treatment liquid 2>

- RC510: Burning surface-treatment liquid made by Agfa

### <Burning surface-treatment liquid 3>

- 804: Burning surface-treatment liquid made by Kodak

### <Burning surface-treatment liquid 4>

- Pre-Bake Solution: Burning surface-treatment liquid made by Allied (2) Printing evaluation

### (1) Staining resistance

The lithographic printing plate manufactured as set forth above was mounted on the plate cylinder of a LITHRONE 26 press made by Komori Corporation. Ecolity-2 (made by FUJIFILM (Ltd.))/tap water = 2/98 (volumetric ratio) fountain solution and Values-G (N) India ink (made by DIC Corporation) were employed. The fountain solution and ink were fed by the standard automatic printing starter method of the LITHRONE 26 to begin printing, and 500 sheets were printed on Art Tokubishi (76.5 kg) paper at a rate of 10,000 sheets/hour. Subsequently, the water setting on the printer was turned down while continuing printing and the quantity of water being fed was gradually reduced until running was seen in the halftone image. The degree to which running staining occurred was evaluated based on the index given below. The results are given in Table 2.
A: Good: running tended not to occur, adequate water/ink balance was present
B: Some running occurred at acceptable levels
C: Running occurred, with a failure level such that halftone shadows collapsed
D: Bad running occurred with just a little water reduction

### (2) The printing durability

After the above staining resistance evaluation, the plate surface was cleaned with Multicleaner E (plate cleaner made by FUJIFILM (Ltd.)) once each 5,000 sheets while continuing printing. Since the image-recording layer wore down gradually as the number of sheets that had been printed increased, the ink density on the printed material decreased. The time when the value measured with a Gretag densitometer for the halftone dot area ratio of 20 µm FM screen 5% halftone dots on the printed material dropped more than 0.5% below the value measured for the 100th sheet printed was determined to be the end of printing. The number of sheets that had been printed at that time was evaluated to be the number of sheets of print resistance. The results are given in Table 2.

**[Table 1]**

| Example | Lithographic printing plate precursor | | Manufacturing process | | | | | |
|---|---|---|---|---|---|---|---|---|
| | Type | Binder polymer | Developer | Water washing | Gum | Surface-treatment liquid | Interval from developing to treatment with surface-treatment liquid | Burning |
| Example 1 | (1) | Polymer 2 | Developer 1 | No | No | Surface-treatment liquid 1 | 2 min | Yes |
| Example 2 | (1) | Polymer 2 | Developer 1 | No | No | Surface-treatment liquid 1 | 5 min | Yes |
| Example 3 | (1) | Polymer 2 | Developer 1 | No | No | Surface-treatment liquid 1 | 1 0 min | Yes |
| Example 4 | (1) | Polymer 2 | Developer 1 | No | No | Surface-treatment liquid 1 | 3 0 min | Yes |
| Example 5 | (1) | Polymer 2 | Developer 1 | No | No | Surface-treatment liquid 1 | 1 hour | Yes |
| Example 6 | (1) | Polymer 2 | Developer 1 | No | No | Surface-treatment liquid 1 | 4 hours | Yes |
| Example 7 | (1) | Polymer 2 | Developer 1 | No | No | Surface-treatment liquid 1 | 8 hours | Yes |
| Example 8 | (1) | Polymer 1 | Developer 1 | No | No | Surface-treatment liquid 1 | 5 min | Yes |
| Example 9 | (1) | Polymer 3 | Developer 1 | No | No | Surface-treatment liquid 1 | 5 min | Yes |
| Example 10 | (1) | Polymer 4 | Developer 1 | No | No | Surface-treatment liquid 1 | 5 min | Yes |
| Example 11 | (1) | Polymer 5 | Developer 1 | No | No | Surface-treatment liquid 1 | 5 min | Yes |
| Example 12 | (1) | Polymer 6 | Developer 1 | No | No | Surface-treatment liquid 1 | 5 min | Yes |
| Example 13 | (1) | Polymer 7 | Developer 1 | No | No | Surface-treatment liquid 1 | 5 min | Yes |
| Example 14 | (1) | Hybrid polymers 1 | Developer 1 | No | No | Surface-treatment liquid 1 | 5 min | Yes |
| Example 15 | (1) | Hybrid polymers 2 | Developer 1 | No | No | Surface-treatment liquid 1 | 5 min | Yes |
| Example 16 | (1) | Hybrid polymer 3 | Developer 1 | No | No | Surface-treatment liquid 1 | 5 min | Yes |
| Example 17 | (1) | Hybrid polymer 4 | Developer 1 | No | No | Surface-treatment liquid 1 | 5 min | Yes |
| Example 18 | (1) | Hybrid polymer 5 | Developer 1 | No | No | Surface-treatment liquid 1 | 5 min | Yes |
| Example 19 | (1) | Hybrid polymer 6 | Developer 1 | No | No | Surface-treatment liquid 1 | 5 min | Yes |
| Example 20 | (1) | Hybridur580 | Developer 1 | No | No | Surface-treatment liquid 1 | 5 min | Yes |
| Example 21 | (1) | Polymer 1 | Developer 2 | No | No | Surface-treatment liquid 1 | 5 min | Yes |
| Example 22 | (1) | Polymer 2 | Developer 2 | No | No | Surface-treatment liquid 1 | 5 min | Yes |
| Example 23 | (1) | Polymer 1 | Developer 3 | No | No | Surface-treatment liquid 1 | 5 min | Yes |
| Example 24 | (1) | Polymer 2 | Developer 3 | No | No | Surface-treatment liquid 1 | 5 min | Yes |
| Example 25 | (1) | Polymer 2 | Developer 1 | No | No | Surface-treatment liquid 2 | 5 min | Yes |
| Example 26 | (1) | Polymer 2 | Developer 1 | No | No | Surface-treatment liquid 3 | 5 min | Yes |
| Example 27 | (1) | Polymer 2 | Developer 1 | No | No | Surface-treatment liquid 4 | 5 min | Yes |
| Comp. Example 1 | (1) | Polymer 2 | Developer 1 | No | No | Surface-treatment liquid 1 | 3 0 s | Yes |
| Comp. Example 2 | (1) | Polymer 2 | Developer 1 | No | No | Surface-treatment liquid 1 | 12 hours | Yes |
| Comp. Example 3 | (1) | Polymer 2 | Developer 1 | Yes | Yes | Surface-treatment liquid 1 | 3 0 s | Yes |
| Comp. Example 4 | (1) | Polymer 2 | Developer 1 | Yes | Yes | Surface-treatment liquid 1 | 5 min | Yes |
| Comp. Example 5 | (1) | Polymer 2 | Developer 1 | Yes | Yes | Surface-treatment liquid 1 | 12 hours | Yes |
| Comp. Example 6 | (1) | Polymer 2 | Developer 1 | No | No | None | - | Yes |
| Comp. Example 7 | (1) | Polymer 2 | Developer 1 | Yes | Yes | None | - | Yes |
| Comp. Example 8 | (1) | Polymer 2 | Developer 1 | No | No | None | - | No |
| Comp. Example 9 | (1) | Polymer 2 | Developer 1 | Yes | Yes | None | - | No |
| Comp. Example 1 0 | (1) | Polymer 2 | Developer 4 | No | No | Surface-treatment liquid 1 | 5 min | Yes |
| Comp. Example 1 1 | (1) | Polymer 2 | Developer 4 | Yes | Yes | Surface-treatment liquid 1 | 5 min | Yes |
| Comp. Example 1 2 | (1) | Polymer 2 | Developer 4 | No | No | None | - | Yes |
| Comp. Example 1 3 | (1) | Polymer 2 | Developer 4 | Yes | Yes | None | - | Yes |
| Comp. Example 1 4 | (1) | Polymer 2 | Developer 4 | No | No | None | - | No |
| Comp. Example 1 5 | (1) | Polymer 2 | Developer 4 | Yes | Yes | None | - | No |

**[Table 2]**

| Example | Developer pH | Quantity of chemical employed | Staining resistance | Printing durability |
|---|---|---|---|---|
| Example 1 | 7.0 | Small quantity | B | 250000 sheets |
| Example 2 | 7.0 | Small quantity | A | 300000 sheets |
| Example 3 | 7.0 | Small quantity | A | 300000 sheets |
| Example 4 | 7.0 | Small quantity | A | 300000 sheets |
| Example 5 | 7.0 | Small quantity | A | 300000 sheets |
| Example 6 | 7.0 | Small quantity | A | 300000 sheets |
| Example 7 | 7.0 | Small quantity | B | 300000 sheets |
| Example 8 | 7.0 | Small quantity | A | 200000 sheets |
| Example 9 | 7.0 | Small quantity | A | 280000 sheets |
| Example 10 | 7.0 | Small quantity | A | 300000 sheets |
| Example 11 | 7.0 | Small quantity | A | 250000 sheets |
| Example 12 | 7.0 | Small quantity | A | 200000 sheets |
| Example 13 | 7.0 | Small quantity | A | 300000 sheets |
| Example 14 | 7.0 | Small quantity | A | 300000 sheets |
| Example 15 | 7.0 | Small quantity | A | 200000 sheets |
| Example 16 | 7.0 | Small quantity | A | 250000 sheets |
| Example 17 | 7.0 | Small quantity | A | 28000 sheets |
| Example 18 | 7.0 | Small quantity | A | 280000 sheets |
| Example 19 | 7.0 | Small quantity | A | 180000 sheets |
| Example 20 | 7.0 | Small quantity | A | 300000 sheets |
| Example 21 | 9.8 | Small quantity | A | 180000 sheets |
| Example 22 | 9.8 | Small quantity | A | 280000 sheets |
| Example 23 | 7.0 | Small quantity | B | 200000 sheets |
| Example 24 | 7.0 | Small quantity | B | 300000 sheets |
| Example 25 | 7.0 | Small quantity | A | 300000 sheets |
| Example 26 | 7.0 | Small quantity | A | 300000 sheets |
| Example 27 | 7.0 | Small quantity | A | 300000 sheets |
| Comp. Example 1 | 7.0 | Small quantity | C | 80000 sheets |
| Comp. Example 2 | 7.0 | Small quantity | D | 300000 sheets |
| Comp. Example 3 | 7.0 | Large quantity | A | 80000 sheets |
| Comp. Example 4 | 7.0 | Large quantity | A | 300000 sheets |
| Comp. Example 5 | 7.0 | Large quantity | B | 300000 sheets |
| Comp. Example 6 | 7.0 | Small quantity | D | 200000 sheets |
| Comp. Example 7 | 7.0 | Large quantity | D | 300000 sheets |
| Comp. Example 8 | 7.0 | Small quantity | B | 80000 sheets |
| Comp. Example 9 | 7.0 | Large quantity | A | 80000 sheets |
| Comp. Example 10 | 12.3 | Small quantity | C | 25000 sheets |
| Comp. Example 11 | 12.3 | Large quantity | A | 300000 sheets |
| Comp. Example 12 | 12.3 | Small quantity | Evaluation impossible | Evaluation impossible |
| Comp. Example 13 | 12.3 | Large quantity | C | 300000 sheets |
| Comp. Example 14 | 12.3 | Small quantity | Evaluation impossible | Evaluation impossible |
| Comp. Example 15 | 12.3 | Large quantity | A | 80000 sheets |

| | | | | |
|---|---|---|---|---|
| * In the table, "Small quantity" means that the water-washing step and gumming step were not conducted. "Large quantity" indicates that at least the water-washing step or the gumming step was conducted. | | | | |

Based on the results in Table 2, each of Example 1 to 27, in which the method for manufacturing lithographic printing plates of the present invention was employed, yielded a lithographic printing plate that had little impact on the environment, employed small quantities of chemicals, and exhibited good printing durability and a low staining resistance.

### (Examples 28 to 159 and Comparative Examples 1 to 39)

### (Preparation of lithographic printing plate precursor (2))

### < Preparation of support 2 >

A degreasing treatment was conducted for 30 seconds at 50°C using a 10 weight% sodium aluminate aqueous solution to remove the rolling oil from the surface of an aluminum sheet (material JIS A 1050) 0.3 mm in thickness. Subsequently, three nylon brushes with embedded clusters of bristles 0.3 mm in diameter and an aqueous dispersion of pumice with a median diameter of 25 µm (specific gravity: 1.1 g/cm³) were used to impart a grain to the aluminum surface, which was then thoroughly washed with water. The sheet was then immersed for 9 seconds in a 25 weight% sodium hydroxide aqueous solution at 45°C to etch it. Following washing with water, the sheet was immersed for another 20 seconds in a 20 weight% nitric acid aqueous solution at 60°C and washed with water. The level of etching of the grained surface at the time was about 3 g/m².

Next, a 60 Hz AC voltage was used to continuously conduct an electrochemical surface roughening treatment. The electrolyte employed was a 1 weight% nitric acid aqueous solution (containing 0.5 weight% aluminum ions) and the temperature of the solution was 50°C. The waveform of the AC power source was such that the time TP that it took the current value to go from zero to the peak was 0.8 ms, the duty ratio was 1:1, and a trapezoid rectangular wave alternating current was employed. A carbon electrode was used as the counter electrode to conduct an electrochemical surface roughening treatment. Ferrite was employed in a supplemental anode. The current density was 30 A/dm² at the peak current value. Five percent of the current flowing in from the power source was shunted off to the supplemental anode. The level of electricity in nitric acid electrolysis was 175 C/dm² when the aluminum sheet was the anode. Subsequently, water washing was conducted by spraying.

Next, the aluminum sheet was subjected to an electrochemical surface roughening treatment at a temperature of 50°C in electrolyte consisting of 0.5 weight% hydrochloric acid aqueous solution (containing 0.5 weight% of aluminum ions) under conditions of an electricity level of 50 C/dm² when the aluminum sheet was the anode by the same method as in the nitric acid electrolysis. Subsequently water washing was conducted by spraying. Next, a 2.5 g/m² DC anode oxide film was provided at a current density of 15 A/dm² using a 15 weight% sulfuric acid aqueous solution (containing 0.5 weight% of aluminum ions) as electrolyte on the sheet, followed by water washing and drying.

Further, 100°C steam was blown for 8 seconds onto the anode oxide film at a pressure of 1.033 x 10⁵ Pa as a hole-sealing treatment.

Subsequently, to ensure the hydrophilic property of the non-image portion, 2.5 weight% of No. 3 sodium silicate aqueous solution was employed for 6 seconds at 75°C to implement a silicate treatment. The quantity of Si that adhered was 10 mg/m². Subsequently, water washing was conducted, yielding support 2. The centerline average roughness (Ra) of this substrate as measured with a needle 2 µm in diameter was 0.51 µm.

### <Forming the undercoating layer>

Next, the undercoating layer coating liquid (1) set forth below was coated on support 2 to a dry coating density of 20 mg/m² to prepare a support having an undercoating layer.

### <Undercoating layer coating liquid (1) >

| | |
|---|---|
| - Undercoating layer compound (1) of the following structure indicated below part | 0.18 |
| - Methanol | 55.24 parts |
| - Water | 6.15 parts |

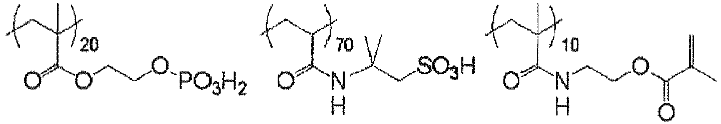

### Undercoating layer compound (1)

### <Formation of image-forming layer 2>

Image-forming layer coating liquid (2) of the composition indicated below was bar coated on the above undercoating layer and then oven dried for 60 seconds at 100°C to form an image-forming layer with a dry coating density of 1.0 g/m².

### <Image-forming layer coating liquid (2)>

| | |
|---|---|
| - The polymer indicated in Table 3 | as solid component 0.540 part |
| - IR-absorbing agent (1) below | 0.030 part |
| - Polymerization initiator (A) below | 0.162 part |
| -Polymerizable compound (tris(acryloyloxyethyl)isocyanurate) (NK ester A-9300, made by Shin Nakamura (Ltd.)) | 0.192 part |
| - Dipentaerythritol pentaacrylate | 0.062 part |
| - Pionin A-20 (made by Takemoto Oil and Fat (Ltd.)) | 0.055 part |
| - Benzyl-dimethyl-octylammonium·PF₆ salt | 0.018 part |
| - Fluorosurfactant (1) below | 0.008 part |
| - Methyl ethyl ketone | 1.091 parts |
| - 1 Methoxy-2-propanol | 8.609 parts |

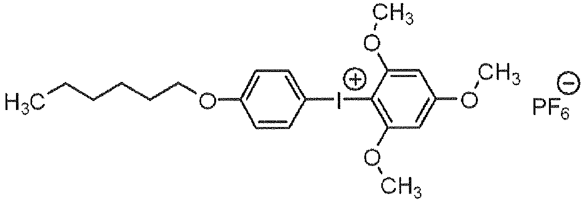

Polymerization initiator (A) 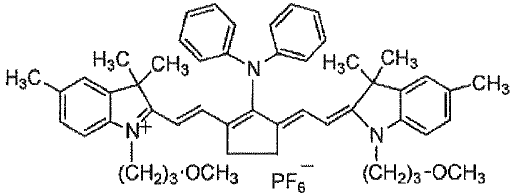 IR-absorbing agent (1)

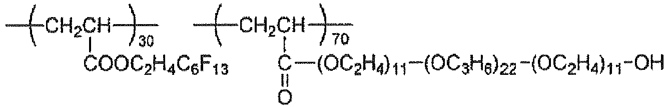

### Fluorosurfactant (1)

### (3) Formation of protective layer

Protective layer coating liquid (2) of the composition indicated below was bar coated on the above image-forming layer and then oven dried for 60 seconds at 120°C to form a protective layer with a dry coating density of 0.15 g/m² and obtain lithographic printing plate precursor (2).

### <Protective layer coating liquid (2)>

- Inorganic layered compound dispersion (1) below 1.5 parts
- Polyvinyl alcohol (CKS50 made by Nippon Synthetic Chemical Industry (Ltd.),
   modified sulfonic acid, degree of saponification 99 mol% or higher, degree of polymerization 300) 6 weight% aqueous solution 0.55 parts
- Polyvinyl alcohol (PVA-405 made by Kuraray (Ltd.), degree of saponification 81.5 mol%, degree of polymerization 500) 6 weight% aqueous solution 0.03 part
- Surfactant made by Nihon-Emulsion (Ltd.)
   (Emarex 710) 1 weight% aqueous solution 0.86 part
- Ion exchange water 6.0 parts

### -- Preparation of inorganic layered compound dispersion (1) --

To 193.6 parts of ion exchange water were added 6.4 parts of synthetic mica Somasif ME-100 (made by Kobe Chemicals (Ltd.)). A homogenizer was then used to disperse the mixture to a mean particle size (laser scattering method) of 3 µm. The aspect ratio of the dispersed particles obtained was 100 or higher.

### (Preparation of lithographic printing plate precursor (3))

### <Preparation of support 3>

Using 2.5 M phosphoric acid as electrolyte, at a voltage of 50 V, and with a maximum current density of 2 A/dm², a 1.5 g/m² DC anode oxide film was provided on an aluminum plate that had been prepared up through the electrochemical surface roughening treatment in the preparation of support 2. Water washing and drying were then conducted.

Next, 100°C steam was blown for 8 seconds onto the anode oxide film at a pressure of 1.033 x 10⁵ Pa as a hole-sealing treatment.

Subsequently, the support was immersed for 10 seconds in a 0.4 weight% polyvinyl phosphonic acid aqueous solution at a solution temperature of 50°C to obtain support 3.

### <Formation of image-forming layer 3 and protective layer>

With the exceptions that support 3 was employed, no undercoating layer was provided, instead of image-forming layer coating liquid (2), image-forming layer coating liquid (3) indicated below was bar coated and oven dried for 90 seconds at 82°C to provide an image-forming layer with a dry coating density of 1.2 g/m², and instead of protective layer coating liquid (2), protective layer coating liquid (3) indicated below was bar coated to obtain a protective layer with a dry coating density of 0.4 g/m², lithographic printing plate precursor (3) was obtained in the same manner as lithographic printing plate precursor (2).

### <Image-forming layer coating liquid (3)>

| | |
|---|---|
| - Polymer indicated in Table 5 | as solid component 4.10 parts |
| - SR399 | 2.66 parts |
| - NK-Ester A-DPH | 2.66 parts |
| - CD9053 | 0.53 parts |
| - Bis-tert-butylphenyliodonium tetraphenylborate | 0.96 parts |
| - Fluor N2900 | 0.11 parts |
| - Pigment 1 | 0.73 parts |
| - IR-absorbing agent (2) below | 0.27 parts |
| - Ion exchange water | 13.77 parts |
| - 1-Methoxy-2-propanol | 48.18 parts |
| - 2-Buyrolactone | 13.77 parts |
| - 2-Butanone | 61.94 parts |

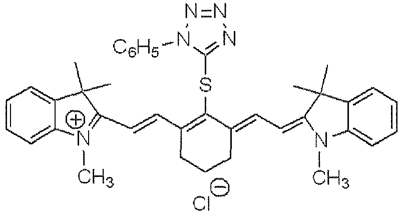

IR-absorbing agent (2)

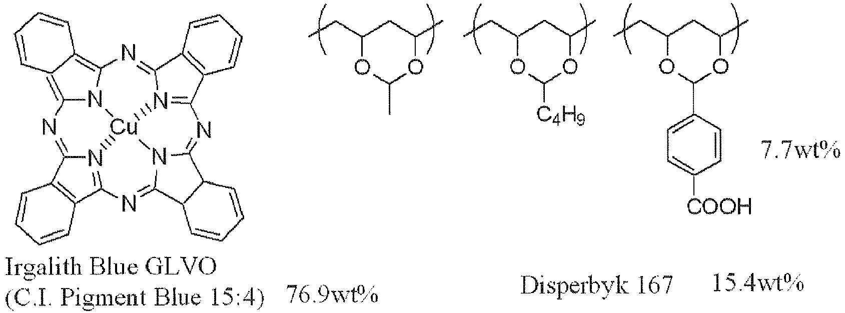

### Pigment 1

### <Protective layer coating liquid (3)>

| | |
|---|---|
| - Polyvinyl alcohol (PVA-405 made by Kuraray (Ltd.), degree of saponification 81.5 mol%, degree of polymerization 500) 6 weight% aqueous solution | 66.33 parts |
| - Masurf 1520 | 0.02 part |
| - Ion exchange water | 8.65 parts |

### <Preparation of lithographic printing plate precursor (4)>

### <Preparation of support 4>

The polyvinyl phosphonic acid treatment in the preparation of support 3 was changed to a polyacrylic acid treatment. That is, an aluminum sheet that had been processed up to just before the polyphosphonic acid treatment in the preparation of support 3 was immersed for 8 seconds in a 1.0 weight% polyacrylic acid aqueous solution with a solution temperature of 25°C, washed, and dried to obtain support 4.

### <Formation of image-forming layer 4>

With the exceptions that no undercoating layer was provided on support 4, instead of image-forming layer coating liquid (1), image-forming layer coating liquid (4) indicated below was bar coated and oven dried for 60 seconds at 70°C to provide an image-forming layer 4 with a dry coating density of 0.6 g/m², and no protective layer was provided, lithographic printing plate precursor (4) was obtained in the same manner as lithographic printing plate precursor (2).

### < Image-forming layer coating liquid 4>

| | |
|---|---|
| - Polymer microparticles indicated below (hydrophobic precursor (component (D)) | 33.0 parts |
| - IR-absorbing agent (3) | 1.0 parts |
| - Low-molecular-weight hydrophilic compound disodium 1,5-naphthalene disulfonate | 0.1 parts |
| - Methanol | 16.0 parts |

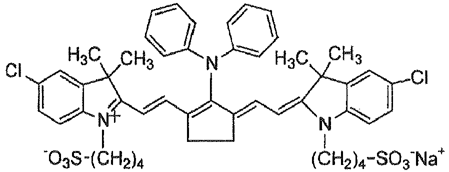

IR-absorbing agent (3)

### (Manufacturing of polymer microparticle (hydrophobic precursor) aqueous dispersion)

A 1,000 mL four-necked flask was equipped with stirrer, thermometer, dropping funnel, nitrogen feed pipe, and reflux condenser. While introducing nitrogen gas to achieve deoxygenation, 350 mL of distilled water was added and heating was conducted to an internal temperature of 80°C. A dispersing agent in the form of 1.5 g of sodium dodecyl sulfate was added, 0.45 g of ammonium persulfide was added as an initiator, and a mixture of 45.0 g of acrylonitrile and 45.0 g of styrene was added dropwise over about an hour through a dropping funnel. Once the dropwise addition had been completed, the reaction was continued for 5 hours in that state. Steam distillation was then used to remove the unreacted monomer. Subsequently, the mixture was cooled, and adjusted to pH 6 with ammonia water. Finally, pure water was added to achieve a nonvolatile component of 15 weight%, yielding a polymer microparticle (hydrophobic precursor) aqueous dispersion. The maximum particle size of the particle size distribution of these polymer particles was 60 nm.

Here, the maximum particle size was determined as follows. An electron microscope photograph was taken of the polymer microparticles. The particle size of a total of 5,000 microparticles in the photograph was measured. The distance from 0 of the maximum particle size measured was divided into a logarithmic scale of 50 increments, and the frequency of occurrence of each particle size was plotted and the maximum particle size was calculated. For aspherical particles, the particle size was determined to be that of a spherical particle of identical surface area on the photograph.

### (1) Exposure and development

Lithographic printing plate precursors (2) and (3) were each exposed under conditions of a resolution of 2,400 dpi, a laser output of 70%, and an outer surface drum rotational speed of 1,000 rpm with a Luxel PLATESETTER T-6000III made by FUJIFILM (Ltd.) mounted with an IR semiconductor laser.

Additionally, lithographic printing plate precursor (4) was exposed under conditions of 2,400 dpi, an outer surface drum rotational speed of 150 rpm, and an output of 10 W with a Trendsetter 3244VX made by Creo mounted with an IR semiconductor laser. The exposure images both contained solid images and fine line images.

Next, the developers recorded in Tables 3, 5, and 7 were employed to conduct development processing at a conveyance speed such that the immersion time (development time) in the developer was 20 seconds in a single-bath automatic developing processor of the configuration shown in Fig. 3 (Examples 28, 55, 82).

In the comparative examples, when water washing and gumming steps were conducted following developing, developing processing was conducted in the same manner as in Example 28 with the exceptions that water washing was conducted with tap water in the second bath and gumming was conducted with finishing gum liquid FN-6 made by FUJIFILM in the third bath using the automatic developing processor of the three-bath structure shown in Fig. 2.

After developing, the lithographic printing plate was treated with a surface-treatment liquid at the time intervals recorded in Tables 3, 5, and 7. The treatment with the surface-treatment liquid was conducted with the burning surface-treatment liquids recorded in Tables 3, 5, and 7 with a dip coater equipped with nip rolls.

Following treatment with the surface-treatment liquid, the lithographic printing plate was processed with an oven throughput time of 3 minutes with prebaking to 150°C and postbaking to a temperature of 240°C with a burning processor made by Tsurumi Corp.

### (2) Printing evaluation

The staining resistance and printing durability of the lithographic printing plates prepared by the above manufacturing process were evaluated by the same procedure as in Example 1. The evaluation results are given in Tables 4, 6, and 8.

**[Table 3]**

| Example | Lithographic printing plate precursor | | Manufacturing process | | | | | |
|---|---|---|---|---|---|---|---|---|
| | Type | Binder polymer | Developer | Water washing | Gum | Surface-treatment liquid | Interval from developing to treatment with surface-treatment liquid | Burning |
| Example 28 | (2) | Polymer 2 | Developer 1 | No | No | Surface-treatment liquid 1 | 2 min | Yes |
| Example 29 | (2) | Polymer 2 | Developer 1 | No | No | Surface-treatment liquid 1 | 5 min | Yes |
| Example 30 | (2) | Polymer 2 | Developer 1 | No | No | Surface-treatment liquid 1 | 10 min | Yes |
| Example 31 | (2) | Polymer 2 | Developer 1 | No | No | Surface-treatment liquid 1 | 30 min | Yes |
| Example 32 | (2) | Polymer 2 | Developer 1 | No | No | Surface-treatment liquid 1 | 1 hour | Yes |
| Example 33 | (2) | Polymer 2 | Developer 1 | No | No | Surface-treatment liquid 1 | 4 hours | Yes |
| Example 34 | (2) | Polymer 2 | Developer 1 | No | No | Surface-treatment liquid 1 | 8 hours | Yes |
| Example 35 | (2) | Polymer 1 | Developer 1 | No | No | Surface-treatment liquid 1 | 5 min | Yes |
| Example 36 | (2) | Polymer 3 | Developer 1 | No | No | Surface-treatment liquid 1 | 5 min | Yes |
| Example 37 | (2) | Polymer 4 | Developer 1 | No | No | Surface-treatment liquid 1 | 5 min | Yes |
| Example 38 | (2) | Polymer 5 | Developer 1 | No | No | Surface-treatment liquid 1 | 5 min | Yes |
| Example 39 | (2) | Polymer 6 | Developer 1 | No | No | Surface-treatment liquid 1 | 5 min | Yes |
| Example 40 | (2) | Polymer 7 | Developer 1 | No | No | Surface-treatment liquid 1 | 5 min | Yes |
| Example 41 | (2) | Hybrid Polymer 1 | Developer 1 | No | No | Surface-treatment liquid 1 | 5 min | Yes |
| Example 42 | (2) | Hybrid Polymer 2 | Developer 1 | No | No | Surface-treatment liquid 1 | 5 min | Yes |
| Example 43 | (2) | Hybrid Polymer 3 | Developer 1 | No | No | Surface-treatment liquid 1 | 5 min | Yes |
| Example 44 | (2) | Hybrid Polymer 4 | Developer 1 | No | No | Surface-treatment liquid 1 | 5 min | Yes |
| Example 45 | (2) | Hybrid Polymer 5 | Developer 1 | No | No | Surface-treatment liquid 1 | 5 min | Yes |
| Example 46 | (2) | Hybrid Polymer 6 | Developer 1 | No | No | Surface-treatment liquid 1 | 5 min | Yes |
| Example 47 | (2) | Hvbridur580 | Developer 1 | No | No | Surface-treatment liquid 1 | 5 min | Yes |
| Example 48 | (2) | Polymer 1 | Developer 2 | No | No | Surface-treatment liquid 1 | 5 min | Yes |
| Example 49 | (2) | Polymer 2 | Developer 2 | No | No | Surface-treatment liquid 1 | 5 min | Yes |
| Example 50 | (2) | Polymer 1 | Developer 3 | No | No | Surface-treatment liquid 1 | 5 min | Yes |
| Example 51 | (2) | Polymer 2 | Developer 3 | No | No | Surface-treatment liquid 1 | 5 min | Yes |
| Example 52 | (2) | Polymer 2 | Developer 1 | No | No | Surface-treatment liquid 2 | 5 min | Yes |
| Example 53 | (2) | Polymer 2 | Developer 1 | No | No | Surface-treatment liquid 3 | 5 min | Yes |
| Example 54 | (2) | Polymer 2 | Developer 1 | No | No | Surface-treatment liquid 4 | 5 min | Yes |
| Comp. Example 16 | (2) | Polymer 2 | Developer 1 | No | No | Surface-treatment liquid 1 | 3 0 s | Yes |
| Comp. Example 17 | (2) | Polymer 2 | Developer 1 | No | No | Surface-treatment liquid 1 | 12 hours | Yes |
| Comp. Example 18 | (2) | Polymer 2 | Developer 1 | Yes | Yes | Surface-treatment liquid 1 | 3 0 s | Yes |
| Comp. Example 19 | (2) | Polymer 2 | Developer 1 | Yes | Yes | Surface-treatment liquid 1 | 5 min | Yes |
| Comp. Example 20 | (2) | Polymer 2 | Developer 1 | Yes | Yes | Surface-treatment liquid 1 | 12 hours | Yes |
| Comp. Example 21 | (2) | Polymer 2 | Developer 1 | No | No | No | - | Yes |
| Comp. Example 22 | (2) | Polymer 2 | Developer 1 | Yes | Yes | No | - | Yes |
| Comp. Example 23 | (2) | Polymer 2 | Developer 1 | No | No | No | - | No |
| Comp. Example 24 | (2) | Polymer 2 | Developer 1 | Yes | Yes | No | - | No |
| Comp. Example 25 | (2) | Polymer 2 | Developer 4 | No | No | Surface-treatment liquid 1 | 5 min | Yes |
| Comp. Example 26 | (2) | Polymer 2 | Developer 4 | Yes | Yes | Surface-treatment liquid 1 | 5 min | Yes |
| Comp. Example 27 | (2) | Polymer 2 | Developer 4 | No | No | No | - | Yes |
| Comp. Example 28 | (2) | Polymer 2 | Developer 4 | Yes | Yes | No | - | Yes |
| Comp. Example 29 | (2) | Polymer 2 | Developer 4 | No | No | No | - | No |
| Comp. Example 30 | (2) | Polymer 2 | Developer 4 | Yes | Yes | No | - | No |

**[Table 4]**

| Example | Developer pH | Quantity of chemical employed | Staining resistance | Printing durability |
|---|---|---|---|---|
| Example 28 | 7.0 | Small quantity | B | 280000 sheets |
| Example 29 | 7.0 | Small quantity | A | 300000 sheets |
| Example 30 | 7.0 | Small quantity | A | 300000 sheets |
| Example 31 | 7.0 | Small quantity | A | 300000 sheets |
| Example 32 | 7.0 | Small quantity | A | 300000 sheets |
| Example 33 | 7.0 | Small quantity | B | 300000 sheets |
| Example 34 | 7.0 | Small quantity | B | 300000 sheets |
| Example 35 | 7.0 | Small quantity | A | 230000 sheets |
| Example 36 | 7.0 | Small quantity | A | 300000 sheets |
| Example 37 | 7.0 | Small quantity | A | 300000 sheets |
| Example 38 | 7.0 | Small quantity | A | 280000 sheets |
| Example 39 | 7.0 | Small quantity | A | 230000 sheets |
| Example 40 | 7.0 | Small quantity | A | 300000 sheets |
| Example 41 | 7.0 | Small quantity | A | 300000 sheets |
| Example 42 | 7.0 | Small quantity | A | 230000 sheets |
| Example 43 | 7.0 | Small quantity | A | 280000 sheets |
| Example 44 | 7.0 | Small quantity | A | 300000 sheets |
| Example 45 | 7.0 | Small quantity | A | 300000 sheets |
| Example 46 | 7.0 | Small quantity | A | 200000 sheets |
| Example 47 | 7.0 | Small quantity | A | 300000 sheets |
| Example 48 | 9.8 | Small quantity | B | 200000 sheets |
| Example 49 | 9.8 | Small quantity | B | 280000 sheets |
| Example 50 | 7.0 | Small quantity | B | 200000 sheets |
| Example 51 | 7.0 | Small quantity | B | 300000 sheets |
| Example 52 | 7.0 | Small quantity | A | 300000 sheets |
| Example 53 | 7.0 | Small quantity | A | 300000 sheets |
| Example 54 | 7.0 | Small quantity | A | 300000 sheets |
| Comp. Example 16 | 7.0 | Small quantity | C | 80000s heets |
| Comp. Example 17 | 7.0 | Small quantity | D | 300000 sheets |
| Comp. Example 18 | 7.0 | Large quantity | A | 80000 sheets |
| Comp. Example 19 | 7.0 | Large quantity | A | 300000 sheets |
| Comp. Example 20 | 7.0 | Large quantity | B | 300000 sheets |
| Comp. Example 21 | 7.0 | Small quantity | D | 230000 sheets |
| Comp. Example 22 | 7.0 | Large quantity | C | 300000 sheets |
| Comp. Example 23 | 7.0 | Small quantity | B | 80000 sheets |
| Comp. Example 24 | 7.0 | Large quantity | A | 80000 sheets |
| Comp. Example 25 | 12.3 | Small quantity | C | 280000 sheets |
| Comp. Example 26 | 12.3 | Large quantity | A | 300000 sheets |
| Comp. Example 27 | 12.3 | Small quantity | Evaluation impossible | Evaluation impossible |
| Comp. Example 28 | 12.3 | Large quantity | C | 300000 sheets |
| Comp. Example 29 | 12.3 | Small quantity | Evaluation impossible | Evaluation impossible |
| Comp. Example 30 | 12.3 | Large quantity | A | 80000 sheets |

| | | | | |
|---|---|---|---|---|
| * In the table, "Small quantity" means that the water-washing step and gumming step were not conducted. "Large quantity" indicates that at least the water-washing step or the gumming step was conducted. | | | | |

Based on the results in Table 4, each of Examples 28 to 54, in which the method for manufacturing lithographic printing plates of the present invention was employed, yielded a lithographic printing plate that had little impact on the environment, employed small quantities of chemicals, and exhibited good print durability and a low staining resistance.

**[Table 5]**

| Example | Lithographic printing plate precursor | | Manufacturing process | | | | | |
|---|---|---|---|---|---|---|---|---|
| | Type | Binder polymer | Developer | Water washing | Gum | Surface-treatment liquid | Interval from developing to treatment with surface-treatment liquid | Burning |
| Example 55 | (3) | Polymer 2 | Developer 1 | No | No | Surface-treatment liquid 1 | 2 min | Yes |
| Example 56 | (3) | Polymer 2 | Developer 1 | No | No | Surface-treatment liquid 1 | 5 min | Yes |
| Example 57 | (3) | Polymer 2 | Developer 1 | No | No | Surface-treatment liquid 1 | 1 0 min | Yes |
| Example 58 | (3) | Polymer 2 | Developer 1 | No | No | Surface-treatment liquid 1 | 3 0 min | Yes |
| Example 59 | (3) | Polymer 2 | Developer 1 | No | No | Surface-treatment liquid 1 | 1 hour | Yes |
| Example 60 | (3) | Polymer 2 | Developer 1 | No | No | Surface-treatment liquid 1 | 4 hours | Yes |
| Example 61 | (3) | Polymer 2 | Developer 1 | No | No | Surface-treatment liquid 1 | 8 hours | Yes |
| Example 62 | (3) | Polymer 1 | Developer 1 | No | No | Surface-treatment liquid 1 | 5 min | Yes |
| Example 63 | (3) | Polymer 3 | Developer 1 | No | No | Surface-treatment liquid 1 | 5 min | Yes |
| Example 64 | (3) | Polymer 4 | Developer 1 | No | No | Surface-treatment liquid 1 | 5 min | Yes |
| Example 65 | (3) | Polymer 5 | Developer 1 | No | No | Surface-treatment liquid 1 | 5 min | Yes |
| Example 66 | (3) | Polymer 6 | Developer 1 | No | No | Surface-treatment liquid 1 | 5 min | Yes |
| Example 67 | (3) | Polymer 7 | Developer 1 | No | No | Surface-treatment liquid 1 | 5 min | Yes |
| Example 68 | (3) | Hybrid Polymer 1 | Developer 1 | No | No | Surface-treatment liquid 1 | 5 min | Yes |
| Example 69 | (3) | Hybrid Polymer 2 | Developer 1 | No | No | Surface-treatment liquid 1 | 5 min | Yes |
| Example 70 | (3) | Hybrid Polymer 3 | Developer 1 | No | No | Surface-treatment liquid 1 | 5 min | Yes |
| Example 71 | (3) | Hybrid Polymer 4 | Developer 1 | No | No | Surface-treatment liquid 1 | 5 min | Yes |
| Example 72 | (3) | Hybrid Polymer 5 | Developer 1 | No | No | Surface-treatment liquid 1 | 5 min | Yes |
| Example 73 | (3) | Hybrid Polymer 6 | Developer 1 | No | No | Surface-treatment liquid 1 | 5 min | Yes |
| Example 74 | (3) | Hybridur580 | Developer 1 | No | No | Surface-treatment liquid 1 | 5 min | Yes |
| Example 75 | (3) | Polymer 1 | Developer 2 | No | No | Surface-treatment liquid 1 | 5 min | Yes |
| Example 76 | (3) | Polymer 2 | Developer 2 | No | No | Surface-treatment liquid 1 | 5 min | Yes |
| Example 77 | (3) | Polymer 1 | Developer 3 | No | No | Surface-treatment liquid 1 | 5 min | Yes |
| Example 78 | (3) | Polymer 2 | Developer 3 | No | No | Surface-treatment liquid 1 | 5 min | Yes |
| Example 79 | (3) | Polymer 2 | Developer 1 | No | No | Surface-treatment liquid 2 | 5 min | Yes |
| Example 80 | (3) | Polymer 2 | Developer 1 | No | No | Surface-treatment liquid 3 | 5 min | Yes |
| Example 81 | (3) | Polymer 2 | Developer 1 | No | No | Surface-treatment liquid 4 | 5 min | Yes |
| Comp. Example 31 | (3) | Polymer 2 | Developer 1 | No | No | Surface-treatment liquid 1 | 30 s | Yes |
| Comp. Example 32 | (3) | Polymer 2 | Developer 1 | No | No | Surface-treatment liquid 1 | 12 hours | Yes |
| Comp. Example 33 | (3) | Polymer 2 | Developer 1 | Yes | Yes | Surface-treatment liquid 1 | 3 0 s | Yes |
| Comp. Example 34 | (3) | Polymer 2 | Developer 1 | Yes | Yes | Surface-treatment liquid 1 | 5 min | Yes |
| Comp. Example 35 | (3) | Polymer 2 | Developer 1 | Yes | Yes | Surface-treatment liquid 1 | 12 hours | Yes |
| Comp. Example 36 | (3) | Polymer 2 | Developer 1 | No | No | No | - | Yes |
| Comp. Example 37 | (3) | Polymer 2 | Developer 1 | Yes | Yes | No | - | Yes |
| Comp. Example 38 | (3) | Polymer 2 | Developer 1 | No | No | No | - | No |
| Comp. Example 39 | (3) | Polymer 2 | Developer 1 | Yes | Yes | No | - | No |
| Comp. Example 40 | (3) | Polymer 2 | Developer 4 | No | No | Surface-treatment liquid 1 | 5 min | Yes |
| Comp. Example 41 | (3) | Polymer 2 | Developer 4 | Yes | Yes | Surface-treatment liquid 1 | 5 min | Yes |
| Comp. Example 42 | (3) | Polymer 2 | Developer 4 | No | No | No | - | Yes |
| Comp. Example 43 | (3) | Polymer 2 | Developer 4 | Yes | Yes | No | - | Yes |
| Comp. Example 44 | (3) | Polymer 2 | Developer 4 | No | No | No | - | No |
| Comp. Example 45 | (3) | Polymer 2 | Developer 4 | Yes | Yes | No | - | No |

**[Table 6]**

| Example | Developer pH | Quantity of chemical employed | Staining resistance | Printing durability |
|---|---|---|---|---|
| Example 55 | 7.0 | Small quantity | B | 300000 sheets |
| Example 56 | 7.0 | Small quantity | A | 300000 sheets |
| Example 57 | 7.0 | Small quantity | A | 300000 sheets |
| Example 58 | 7.0 | Small quantity | A | 300000 sheets |
| Example 59 | 7.0 | Small quantity | B | 300000 sheets |
| Example 60 | 7.0 | Small quantity | B | 300000 sheets |
| Example 61 | 7.0 | Small quantity | B | 300000 sheets |
| Example 62 | 7.0 | Small quantity | A | 250000 sheets |
| Example 63 | 7.0 | Small quantity | B | 300000 sheets |
| Example 64 | 7.0 | Small quantity | A | 300000 sheets |
| Example 65 | 7.0 | Small quantity | A | 300000 sheets |
| Example 66 | 7.0 | Small quantity | A | 250000 sheets |
| Example 67 | 7.0 | Small quantity | B | 300000 sheets |
| Example 68 | 7.0 | Small quantity | B | 300000 sheets |
| Example 69 | 7.0 | Small quantity | A | 250000 sheets |
| Example 70 | 7.0 | Small quantity | A | 300000 sheets |
| Example 71 | 7.0 | Small quantity | A | 300000 sheets |
| Example 72 | 7.0 | Small quantity | B | 300000 sheets |
| Example 73 | 7.0 | Small quantity | A | 230000 sheets |
| Example 74 | 7.0 | Small quantity | A | 300000 sheets |
| Example 75 | 9.8 | Small quantity | B | 230000 sheets |
| Example 76 | 9.8 | Small quantity | B | 280000 sheets |
| Example 77 | 7.0 | Small quantity | B | 230000 sheets |
| Example 78 | 7.0 | Small quantity | B | 300000 sheets |
| Example 79 | 7.0 | Small quantity | A | 300000 sheets |
| Example 80 | 7.0 | Small quantity | A | 300000 sheets |
| Example 81 | 7.0 | Small quantity | B | 300000 sheets |
| Comp. Example 31 | 7.0 | Small quantity | C | 80000s heets |
| Comp. Example 32 | 7.0 | Small quantity | D | 300000 sheets |
| Comp. Example 33 | 7.0 | Large quantity | B | 80000 sheets |
| Comp. Example 34 | 7.0 | Large quantity | B | 30000 0sheets |
| Comp. Example 35 | 7.0 | Large quantity | B | 300000 sheets |
| Comp. Example 36 | 7.0 | Small quantity | D | 250000 sheets |
| Comp. Example 37 | 7.0 | Large quantity | C | 300000 sheets |
| Comp. Example 38 | 7.0 | Small quantity | B | 80000 sheets |
| Comp. Example 39 | 7.0 | Large quantity | B | 80000 sheets |
| Comp. Example 40 | 12.3 | Small quantity | C | 300000 sheets |
| Comp. Example 41 | 12.3 | Large quantity | B | 300000 sheets |
| Comp. Example 42 | 12.3 | Small quantity | Evaluation impossible | Evaluation impossible |
| Comp. Example 43 | 12.3 | Large quantity | C | 300000 sheets |
| Comp. Example 44 | 12.3 | Small quantity | Evaluation impossible | Evaluation impossible |
| Comp. Example 45 | 12.3 | Large quantity | B | 80000 sheets |

| | | | | |
|---|---|---|---|---|
| * In the table, "Small quantity" means that the water-washing step and gumming step were not conducted. "Large quantity" indicates that at least the water-washing step or the gumming step was conducted. | | | | |

Based on the results in Table 6, each of Examples 55 to 81, in which the method for manufacturing lithographic printing plates of the present invention was employed, yielded a lithographic printing plate that had little impact on the environment, employed small quantities of chemicals, and exhibited good print durability and a low staining resistance.

**[Table 7]**

| Example | Lithographic printing plate precursor | Manufacturing process | | | | | |
|---|---|---|---|---|---|---|---|
| | Type | Developer | Water washing | Gum | Surface-treatment liquid | Interval from developing to treatment with surface-treatment liquid | Burning |
| Example 82 | (4) | Developer 1 | No | No | Surface-treatment liquid 1 | 2 min | Yes |
| Example 83 | (4) | Developer 1 | No | No | Surface-treatment liquid 1 | 5 min | Yes |
| Example 84 | (4) | Developer 1 | No | No | Surface-treatment liquid 1 | 1 0 min | Yes |
| Example 85 | (4) | Developer 1 | No | No | Surface-treatment liquid 1 | 3 0 min | Yes |
| Example 86 | (4) | Developer 1 | No | No | Surface-treatment liquid 1 | 1 hour | Yes |
| Example 87 | (4) | Developer 1 | No | No | Surface-treatment liquid 1 | 4 hours | Yes |
| Example 88 | (4) | Developer 1 | No | No | Surface-treatment liquid 1 | 8 hours | Yes |
| Example 89 | (4) | Developer 2 | No | No | Surface-treatment liquid 1 | 5 min | Yes |
| Example 90 | (4) | Developer 3 | No | No | Surface-treatment liquid 1 | 5 min | Yes |
| Example 91 | (4) | Developer 1 | No | No | Surface-treatment liquid 2 | 5 min | Yes |
| Example 92 | (4) | Developer 1 | No | No | Surface-treatment liquid 3 | 5 min | Yes |
| Example 93 | (4) | Developer 1 | No | No | Surface-treatment liquid 4 | 5 min | Yes |
| Comp. Example 46 | (4) | Developer 1 | No | No | Surface-treatment liquid 1 | 3 0 s | Yes |
| Comp. Example 47 | (4) | Developer 1 | No | No | Surface-treatment liquid 1 | 12 hours | Yes |
| Comp. Example 48 | (4) | Developer 1 | Yes | Yes | Surface-treatment liquid 1 | 30 s | Yes |
| Comp. Example 49 | (4) | Developer 1 | Yes | Yes | Surface-treatment liquid 1 | 5 min | Yes |
| Comp. Example 50 | (4) | Developer 1 | Yes | Yes | Surface-treatment liquid 1 | 12 hours | Yes |
| Comp. Example 51 | (4) | Developer 1 | No | No | No | - | Yes |
| Comp. Example 52 | (4) | Developer 1 | Yes | Yes | No | - | Yes |
| Comp. Example 53 | (4) | Developer 1 | No | No | No | - | No |
| Comp. Example 54 | (4) | Developer 1 | Yes | Yes | No | - | No |
| Comp. Example 55 | (4) | Developer 4 | No | No | Surface-treatment liquid 1 | 5 min | Yes |
| Comp. Example 56 | (4) | Developer 4 | Yes | Yes | Surface-treatment liquid 1 | 5 min | Yes |
| Comp. Example 57 | (4) | Developer 4 | No | No | No | - | Yes |
| Comp. Example 58 | (4) | Developer 4 | Yes | Yes | No | - | Yes |
| Comp. Example 59 | (4) | Developer 4 | No | No | No | - | No |
| Comp. Example 60 | (4) | Developer 4 | Yes | Yes | No | - | No |

**[Table 8]**

| Example | Developer pH | Quantity of chemical employed | Staining resistance | Printing durability |
|---|---|---|---|---|
| Example 82 | 7.0 | Small quantity | B | 200000 sheets |
| Example 83 | 7.0 | Small quantity | A | 250000 sheets |
| Example 84 | 7.0 | Small quantity | A | 250000 sheets |
| Example 85 | 7.0 | Small quantity | A | 250000 sheets |
| Example 86 | 7.0 | Small quantity | B | 250000 sheets |
| Example 87 | 7.0 | Small quantity | B | 250000 sheets |
| Example 88 | 7.0 | Small quantity | B | 250000 sheets |
| Example 89 | 9.8 | Small quantity | B | 230000 sheets |
| Example 90 | 7.0 | Small quantity | B | 250000 sheets |
| Example 91 | 7.0 | Small quantity | B | 25000 sheets |
| Example 92 | 7.0 | Small quantity | A | 250000 sheets |
| Example 93 | 7.0 | Small quantity | A | 250000 sheets |
| Comp. Example 46 | 7.0 | Small quantity | C | 30000 sheets |
| Comp. Example 47 | 7.0 | Small quantity | D | 250000 sheets |
| Comp. Example 48 | 7.0 | Large quantity | A | 30000 sheets |
| Comp. Example 49 | 7.0 | Large quantity | A | 250000 sheets |
| Comp. Example 50 | 7.0 | Large quantity | B | 250000 sheets |
| Comp. Example 51 | 7.0 | Small quantity | D | 150000 sheets |
| Comp. Example 52 | 7.0 | Large quantity | C | 250000 sheets |
| Comp. Example 53 | 7.0 | Small quantity | B | 30000 sheets |
| Comp. Example 54 | 7.0 | Large quantity | A | 80000 sheets |
| Comp. Example 55 | 12.3 | Small quantity | C | 200000 sheets |
| Comp. Example 56 | 12.3 | Large quantity | A | 250000 sheets |
| Comp. Example 57 | 12.3 | Small quantity | Evaluation impossible | Evaluation impossible |
| Comp. Example 58 | 12.3 | Large quantity | C | 250000 sheets |
| Comp. Example 59 | 12.3 | Small quantity | Evaluation impossible | Evaluation impossible |
| Comp. Example 60 | 12.3 | Large quantity | A | 30000 sheets |

| | | | | |
|---|---|---|---|---|
| * In the table, "Small quantity" means that the water-washing step and gumming step were not conducted. "Large quantity" indicates that at least the water-washing step or the gumming step was conducted. | | | | |

Based on the results in Table 8, each of Examples 82 to 93, in which the method for manufacturing lithographic printing plates of the present invention was employed, yielded a lithographic printing plate that had little impact on the environment, employed small quantities of chemicals, and exhibited good print durability and a low staining resistance.

## Claims

1. A method for manufacturing lithographic printing plates comprising
(A) exposing to a negative-type lithographic printing plate precursor comprising an image-forming layer that is curable by exposure to light on a support having a hydrophilic surface;
(B) developing with a developer having a pH of 4 to 10 the negative-type lithographic printing plate precursor that has been exposed;
(C) treating with a burning surface-treatment liquid the negative-type lithographic printing plate precursor that has been developed; and
(D) subjecting the negative-type lithographic printing plate precursor to a burning treatment; and
by an interval between the developing (B) and the treating with a burning surface-treatment liquid (C) of from 1 minute or more to 10 hours or less, during which time no water-washing or gumming is incorporated.

2. The method for manufacturing lithographic printing plates according to claim 1, wherein the interval between the developing (B) and the treating with a burning surface-treatment liquid (C) is from 2 minutes or more to 5 hours or less.

3. The method for manufacturing lithographic printing plates according to claim 1, wherein the interval between the developing (B) and the treating with a burning surface-treatment liquid (C) is from 3 minutes or more to 3 hours or less.

4. The method for manufacturing lithographic printing plates according to any one of claims 1 to 3, wherein the developer has a pH of 6 to 8.

5. The method for manufacturing lithographic printing plates according to any one of claims 1 to 4, wherein the image-forming layer comprises at least one from among (i) an acrylic polymer having a monomer unit derived from a vinyl carbazole compound, and/or a urethane-acrylic hybrid polymer; (ii) butyral resin, and (iii) a hydrophobic precursor.

6. The method for manufacturing lithographic printing plates according to any one of claims 1 to 4, wherein the image-forming layer comprises butyral resin.

7. The method for manufacturing lithographic printing plates according to claim 6, wherein the butyral resin further comprises a monomer unit derived from a vinyl ester of trimellitic acid.

8. The method for manufacturing lithographic printing plates according to any one of claims 1 to 4, wherein the image-forming layer comprises an acrylic polymer having a monomer unit derived from a vinyl carbazole compound, and/or a urethane-acrylic hybrid polymer.

9. The method for manufacturing lithographic printing plates according to claim 8, wherein the acrylic polymer further comprises a monomer unit derived from acrylonitrile.

10. The method for manufacturing lithographic printing plates according to claim 8, wherein the urethane-acrylic hybrid polymer comprises a monomer unit derived from a compound selected from the group consisting of diphenylmethane diisocyanate, m-tolylene diisocyanate, isophorone diisocyanate, and dichlorohexylmethane diisocyanate.

11. The method for manufacturing lithographic printing plates according to any one of claims 1 to 4, wherein the image-forming layer comprises hydrophobic thermoplastic polymer microparticles.

12. The method for manufacturing lithographic printing plates according to claim 11, wherein the hydrophobic thermoplastic polymer microparticles are comprised of a copolymer having monomer units derived from acrylonitrile and styrene.

13. The method for manufacturing lithographic printing plates according to any one of claims 1 to 12, wherein the image-forming layer has sensitivity to light in a wavelength region of from 350 to 450 nm, and the exposing (A) is conducted by irradiating a violet laser beam.

14. The method for manufacturing lithographic printing plates according to any one of claims 1 to 12, wherein the image-forming layer has sensitivity to light in a wavelength region of from 750 to 1,400 nm, and the exposing (A) is conducted by irradiating an infrared laser beam.

## Patentansprüche

1. Verfahren zur Herstellung von Lithographiedruckplatten, umfassend
(A) Belichten eines Lithographiedruckplattenvorläufers vom Negativtyp, der auf einem Träger mit einer hydrophilen Oberfläche eine bildgebende Schicht umfasst, die durch Belichtung gehärtet werden kann;
(B) Entwickeln des Lithographiedruckplattenvorläufers vom Negativtyp, der belichtet worden ist, mit einem Entwickler mit einem pH-Wert von 4 bis 10;
(C) Behandeln des Lithographiedruckplattenvorläufers vom Negativtyp, der entwickelt worden ist, mit einer Brenn-Oberflächenbehandlungsflüssigkeit; und
(D) Unterziehen des Lithographiedruckplattenvorläufer vom Negativtyp unter eine Brenn-Behandlung; und
wobei der Zeitabstand zwischen dem Entwickeln (B) und dem Behandeln mit einer Brenn-Oberflächenbehandlungsflüssigkeit (C) von 1 Minute oder mehr bis 10 Stunden oder weniger beträgt, wobei während dieser Zeit kein Wasserwaschen oder Gummieren durchgeführt wird.

2. Verfahren zur Herstellung von Lithographiedruckplatten gemäß Anspruch 1, worin der Zeitabstand zwischen dem Entwickeln (B) und dem Behandeln mit einer Brenn-Oberflächenbehandlungsflüssigkeit (C) von 2 Minuten oder mehr bis 5 Stunden oder weniger beträgt.

3. Verfahren zur Herstellung von Lithographiedruckplatten gemäß Anspruch 1, worin der Zeitabstand zwischen dem Entwickeln (B) und dem Behandeln mit einer Brenn-Oberflächenbehandlungsflüssigkeit (C) von 3 Minuten oder mehr bis 3 Stunden oder weniger beträgt.

4. Verfahren zur Herstellung von Lithographiedruckplatten gemäß irgendeinem der Ansprüche 1 bis 3, worin der Entwickler einen pH-Wert von 6 bis 8 aufweist.

5. Verfahren zur Herstellung von Lithographiedruckplatten gemäß irgendeinem der Ansprüche 1 bis 4, worin die bildgebende Schicht mindestens eines umfasst, ausgewählt aus (i) einem Acrylpolymer mit einer Monomereinheit, die aus einer Vinylcarbazolverbindung erhalten ist, und/oder ein Urethan-Acryl-Hybridpolymer; (ii) einem Butyralharz und (iii) einem hydrophoben Vorläufer.

6. Verfahren zur Herstellung von Lithographiedruckplatten gemäß irgendeinem der Ansprüche 1 bis 4, worin die bildgebende Schicht ein Butyralharz umfasst.

7. Verfahren zur Herstellung von Lithographiedruckplatten gemäß Anspruch 6, worin das Butyralharz ferner eine Monomereinheit umfasst, die aus einem Vinylester von Trimellitsäure erhalten ist.

8. Verfahren zur Herstellung von Lithographiedruckplatten gemäß irgendeinem der Ansprüche 1 bis 4, worin die bildgebende Schicht ein Acrylpolymer, das eine Monomereinheit aufweist, die aus einer Vinylcarbazolverbindung erhalten ist, und/oder ein Urethan-Acryl-Hybridpolymer umfasst.

9. Verfahren zur Herstellung von Lithographiedruckplatten gemäß Anspruch 8, worin das Acrylpolymer ferner eine Monomereinheit umfasst, die aus Acrylnitril abgeleitet ist.

10. Verfahren zur Herstellung von Lithographiedruckplatten gemäß Anspruch 8, worin das Urethan-Acryl-Hybridpolymer eine Monomereinheit umfasst, die aus einer Verbindung abgeleitet ist, die ausgewählt ist aus der Gruppe, bestehend aus Diphenylmethandiisocyanat, m-Tolylendiisocyanat, Isophorondiisocyanat und Dichlorhexylmethandiisocyanat.

11. Verfahren zur Herstellung von Lithographiedruckplatten gemäß irgendeinem der Ansprüche 1 bis 4, worin die bildgebende Schicht hydrophobe thermoplastische Polymer-Mikropartikel umfasst.

12. Verfahren zur Herstellung von Lithographiedruckplatten gemäß Anspruch 11, worin die hydrophoben thermoplastischen Polymer-Mikropartikel aus einem Copolymer aufgebaut sind, das Monomereinheiten aufweist, die aus Acrylnitril und Styrol abgeleitet sind.

13. Verfahren zur Herstellung von Lithographiedruckplatten gemäß irgendeinem der Ansprüche 1 bis 12, worin die bildgebende Schicht Lichtempfindlichkeit im Wellenlängenbereich von 350 bis 450 nm aufweist, und das Belichten (A) durch Bestrahlen mit einem Violett-Laserstrahl durchgeführt wird.

14. Verfahren zur Herstellung von Lithographiedruckplatten gemäß irgendeinem der Ansprüche 1 bis 12, worin die bildgebende Schicht Lichtempfindlichkeit im Wellenlängenbereich von 750 bis 1.400 nm aufweist und das Belichten (A) durch Bestrahlug mit einem Infrarot-Laserstrahl durchgeführt wird.

## Revendications

1. Procédé de fabrication de plaques d'impression lithographique, comprenant
(A) l'exposition d'un précurseur de plaque d'impression lithographique de type négatif comprenant une couche de formation d'image qui est durcissable par exposition à une lumière sur un support ayant une surface hydrophile ;
(B) le développement avec un révélateur ayant un pH de 4 à 10 du précurseur de plaque d'impression lithographique de type négatif qui a été exposé ;
(C) le traitement avec un liquide de traitement de surface par brûlage du précurseur de plaque d'impression lithographique de type négatif qui a été développé ; et
(D) la soumission du précurseur de plaque d'impression lithographique de type négatif à un traitement de brûlage ; et
en maintenant un intervalle entre le développement (B) et le traitement avec un liquide de traitement de surface par brûlage (C) de 1 minute ou plus à 10 heures ou moins, durée pendant laquelle aucun lavage à l'eau ou gommage n'est incorporé.

2. Procédé de fabrication de plaques d'impression lithographique selon la revendication 1, dans lequel l'intervalle entre le développement (B) et le traitement avec un liquide de traitement de surface par brûlage (C) est de 2 minutes ou plus à 5 heures ou moins.

3. Procédé de fabrication de plaques d'impression lithographique selon la revendication 1, dans lequel l'intervalle entre le développement (B) et le traitement avec un liquide de traitement de surface par brûlage (C) est de 3 minutes ou plus à 3 heures ou moins.

4. Procédé de fabrication de plaques d'impression lithographique selon l'une quelconque des revendications 1 à 3, dans lequel le révélateur possède un pH de 6 à 8.

5. Procédé de fabrication de plaques d'impression lithographique selon l'une quelconque des revendications 1 à 4, dans lequel la couche de formation d'image comprend au moins l'un(e) ou l'autre (i) d'un polymère acrylique contenant un motif monomère dérivé d'un composé de vinylcarbazole et/ou d'un polymère hybride d'uréthane/acrylique ; (ii) d'une résine de butyral et (iii) d'un précurseur hydrophobe.

6. Procédé de fabrication de plaques d'impression lithographique selon l'une quelconque des revendications 1 à 4, dans lequel la couche de formation d'image comprend une résine de butyral.

7. Procédé de fabrication de plaques d'impression lithographique selon la revendication 6, dans lequel la résine de butyral comprend en outre un motif monomère dérivé d'un ester de vinyle de l'acide trimellitique.

8. Procédé de fabrication de plaques d'impression lithographique selon l'une quelconque des revendications 1 à 4, dans lequel la couche de formation d'image comprend un polymère acrylique contenant un motif monomère dérivé d'un composé de vinylcarbazole et/ou un polymère hybride d'uréthane/acrylique.

9. Procédé de fabrication de plaques d'impression lithographique selon la revendication 8, dans lequel le polymère acrylique comprend en outre un motif monomère dérivé de l'acrylonitrile.

10. Procédé de fabrication de plaques d'impression lithographique selon la revendication 8, dans lequel le polymère hybride d'uréthane/acrylique comprend un motif monomère dérivé d'un composé choisi dans le groupe constitué du diisocyanate de diphénylméthane, du diisocyanate de m-tolylène, du diisocyanate d'isophorone et du diisocyanate de dichlorohexylméthane.

11. Procédé de fabrication de plaques d'impression lithographique selon l'une quelconque des revendications 1 à 4, dans lequel la couche de formation d'image comprend des microparticules de polymère thermoplastique hydrophobe.

12. Procédé de fabrication de plaques d'impression lithographique selon la revendication 11, dans lequel les microparticules de polymère thermoplastique hydrophobe sont composées d'un copolymère contenant des motifs monomères dérivés de l'acrylonitrile et du styrène.

13. Procédé de fabrication de plaques d'impression lithographique selon l'une quelconque des revendications 1 à 12, dans lequel la couche de formation d'image est sensible à la lumière dans une région de longueurs d'onde de 350 nm à 450 nm et l'exposition (A) est réalisée en irradiant un faisceau laser violet.

14. Procédé de fabrication de plaques d'impression lithographique selon l'une quelconque des revendications 1 à 12, dans lequel la couche de formation d'image est sensible à la lumière dans une région de longueurs d'onde de 750 nm à 1400 nm et l'exposition (A) est réalisée en irradiant un faisceau laser infrarouge.
